# EUROPEAN PATENT APPLICATION

(11) **EP 4 180 824 A1**
(43) Date of publication of application: **17.05.2023**
(21) Application number: 21208078.2
(22) Date of filing: 12.11.2021
(51) Int. Cl.: G01R 19/25, H02B 1/20, G05B 19/042, H02B 1/21

(54) **FUNCTION ENHANCEMENT CONTROL CABINET BUSBAR MODULE**

(71) Applicant: Future Systems Besitz GmbH, 96472 Rödental (DE)
(72) Inventor: SPIEL, Peter, 93049 Regensburg (DE); FÖRST, Bernhard, 96317 Kronach (DE)
(74) Representative: Isarpatent

(57) **Abstract**

A Function Enhancement Control Cabinet Module, FECCM, (1) for a control cabinet (13) comprising at least one energy interface (2) for connection of said Function Enhancement Control Cabinet Module, FECCM, (1) to a power distribution system (14) of said control cabinet (13); at least one application device interface (3) for connection and power supply of at least one application device (15) to said Function Enhancement Control Cabinet Module, FECCM, (1); a control interface (4) for connection of said Function Enhancement Control Cabinet Module, FECCM, (1) to an external controller (17); a user visualization interface (5) adapted to provide output information to a user and/or to receive user input commands from a user of said control cabinet (13); at least one measurement unit, MU, (6) provided between the energy interface (2) and the application device interface (3) to provide measurement data, MDATA, to a data processing unit, DPU, (7) of said Function Enhancement Control Cabinet Module, FECCM, (1) being galvanically isolated from said measurement unit, MU, (6) and adapted to exchange control information and data with the external controller (17) connected to the control interface (4) of the Function Enhancement Control Cabinet Module, FECCM, (1).

## Description

The invention relates to a Function Enhancement Control Cabinet Busbar Module for a control cabinet of an automation system.

A control cabinet can comprise a variety of application devices which can be used to connect devices to a power distribution system of the control cabinet. The application devices can perform different technical functions within the automation system. The application devices can comprise for instance load switches, motor controllers or frequency inverters. In a conventional automation and control system, monitoring of the operation of application devices and connected load devices as well as monitoring of the operation states of the different devices mounted within the control cabinet is limited since a sufficient database is missing.

Accordingly, it is an object of the present invention to provide a Function Enhancement Control Cabinet Busbar Module for a control cabinet providing reliable measurement data for monitoring and/or controlling functions performed by application devices mounted within the respective control cabinet.

This object is achieved by a Function Enhancement Control Cabinet Busbar Module comprising the features of claim 1.

The invention provides according to a further aspect a Function Enhancement Control Cabinet Module for a control cabinet comprising
at least one energy interface for connection of said Function Enhancement Control Cabinet Module to a power distribution system of said control cabinet,
at least one application device interface for connection and power supply of at least one application device connected to said Function Enhancement Control Cabinet Module,
a control interface for connection of said Function Enhancement Control Cabinet Module to a control cabinet controller of said control cabinet, and
at least one measurement unit provided between the energy interface and the application device interface to provide measurement data to a data processing unit of said Function Enhancement Control Cabinet Module being galvanically isolated from said measurement unit and adapted to exchange control information and data with the control cabinet controller connected to the control interface of the Function Enhancement Control Cabinet Module.

In a preferred embodiment the Function Enhancement Control Cabinet Module comprises a user visualization interface adapted to provide output information to a user and/or to receive user input commands from a user of said control cabinet.

In a possible embodiment of the Function Enhancement Control Cabinet Module, the module comprises at least one internal bidirectional power supply path provided between the energy interface at a rear side of the housing of the Function Enhancement Control Cabinet Module and the application device interface provided at a front side of the housing of the Function Enhancement Control Cabinet Module.

The internal bidirectional power supply path is adapted to feed electrical power from the power distribution system of the control cabinet connected to the energy interface provided at the rear side of the housing of the Function Enhancement Control Cabinet Module in a forward power supply direction to the application device connected to the application device interface provided at the front side of the housing of the Function Enhancement Control Cabinet Module or is adapted to feed electrical power in a reverse power supply direction from the application device connected to the application device interface provided at the front side of the housing of the Function Enhancement Control Cabinet Module to the power distribution system of the control cabinet connected to the energy interface provided at the rear side of the housing of the Function Enhancement Control Cabinet Module.

On the front face of the application device connected to the application device interface provided at a front side of the housing of the Function Enhancement Control Cabinet Module, one or more electrical loads can be connected to receive electrical power from the application device through said application device interface. In this case, the load devices which consume electrical power receive electrical power from the power distribution system of the control cabinet in a forward power supply direction of the power supply path.

The load wiring also can be placed on top or bottom side of the application device.

It is also possible that power generation devices are connected to the application device feeding power through the application device and through the application device interface and through the power supply path of the Function Enhancement Control Cabinet Module into the power distribution system of the control cabinet. In this case, electrical power is fed in reverse power supply direction from the application device into the power distribution system of the control cabinet.

The application device connected to the application device interface of the Function Enhancement Control Cabinet Module can perform different kinds of functions and may comprise for instance a contactor or load switch, a motor control apparatus, a fuse holder, for instance a frequency inverter. The application device connected to the application device interface of the Function Enhancement Control Cabinet Module can provide overcurrent protection and/or overload protection for a load device connected to the respective application device. The application device may also comprise an adapter device. The application device is in a preferred embodiment only in charge of these functions while connected to and controlled by the FECCM.

In a further possible embodiment of the Function Enhancement Control Cabinet Module according to the first aspect of the present invention, a measurement unit included in the housing of the Function Enhancement Control Cabinet Module comprises at least one current sensor adapted to measure an electrical current flowing through the bidirectional power supply path of the Function Enhancement Control Cabinet Module.

In a further possible embodiment of the Function Enhancement Control Cabinet Module according to the first aspect of the present invention, the measurement unit included in the housing of the Function Enhancement Control Cabinet Module comprises at least one voltage sensor adapted to measure an electrical voltage at the energy interface provided at the rear side of the housing of the Function Enhancement Control Cabinet Module and/or to measure an electrical voltage at the application device interface provided at a front side of the housing of the Function Enhancement Control Cabinet Module.

In a further possible embodiment of the Function Enhancement Control Cabinet Module according to the first aspect of the present invention, the measurement unit included in the housing of the Function Enhancement Control Cabinet Module comprises at least one temperature sensor adapted to measure a temperature inside the housing of the Function Enhancement Control Cabinet Module and to provide the galvanically isolated data processing unit of the Function Enhancement Control Cabinet Module with corresponding measurement data.

Accordingly, the Function Enhancement Control Cabinet Module may comprise different kinds or types of sensor elements which are adapted to provide sensor signals used to provide measurement data being preprocessed or processed by the data processing unit of the Function Enhancement Control Cabinet Module in real time during the operation of the control cabinet.

In a possible embodiment of the Function Enhancement Control Cabinet Module according to the first aspect of the present invention, an application device operation state of the at least one application device connected to the application device interface provided at a front side of the housing of said Function Enhancement Control Cabinet Module and/or an operation state of a load device connected to the respective application device is determined by the data processing unit of the Function Enhancement Control Cabinet Module by evaluation of the measurement data received by the data processing unit from the measurement unit of the Function Enhancement Control Cabinet Module.

In a further possible embodiment, the application device operation state is notified to the data processing unit of the Function Enhancement Control Cabinet Module through a communication link of a control entity of the application device connected to the application device interface of said Function Enhancement Control Cabinet Module.

In a further possible embodiment of the Function Enhancement Control Cabinet Module according to the first aspect of the present invention, a power supply state of the power distribution system connected to the energy interface provided at a rear side of the housing of said Function Enhancement Control Cabinet Module is determined by evaluation of the measurement data received by the data processing unit of the Function Enhancement Control Cabinet Module from the measurement unit of the Function Enhancement Control Cabinet Module.

In a still further possible embodiment of the Function Enhancement Control Cabinet Module according to the first aspect of the present invention, the user visualization interface comprises a touch sensitive user visualization interface which is connected to the data processing unit of the Function Enhancement Control Cabinet Module and which is adapted to display an application device operation state, in particular an operation failure state, of the at least one application device connected to the application device interface provided at the front side of the housing of the Function Enhancement Control Cabinet Module and/or to display an operation state of a load connected to the respective application device.

In a further possible embodiment of the Function Enhancement Control Cabinet Module according to the first aspect of the present invention, the touch sensitive user visualization interface of the Function Enhancement Control Cabinet Module is adapted to display a power supply state of the power distribution system of the control cabinet connected to the energy interface provided at the rear side of the housing of the Function Enhancement Control Cabinet Module.

In a further possible embodiment of the Function Enhancement Control Cabinet Module, the touch sensitive user visualization interface is further adapted to receive user input commands of a user of the control cabinet touching a touch sensitive layer of the user visualization interface.

In a further possible embodiment of the Function Enhancement Control Cabinet Module according to the first aspect of the present invention, the data processing unit of the Function Enhancement Control Cabinet Module is adapted to identify a type of the at least one application device connected to the application device interface at a front side of the housing of the Function Enhancement Control Cabinet Module and/or to identify a type of a load device connected to the application device based on a stored current profile and stored voltage profile and/or based on application device identification data received by the Function Enhancement Control Cabinet Module from a control entity of the connected application device via a wired application device control interface or via a wireless application device control interface.

In a possible implementation of the Function Enhancement Control Cabinet Module according to the first aspect of the present invention, the wireless application device control interface comprises an RFID interface, a Near Field Communication, NFC, interface, a WiFi interface or a Bluetooth interface.

Accordingly, the Function Enhancement Control Cabinet Module can comprise in a possible implementation at least one application device interface provided for electrical power supply and an associated application device control interface provided for exchanging control signals between a control entity of the application device and a controller integrated in the data processing unit of the Function Enhancement Control Cabinet Module.

In a still further possible embodiment of the Function Enhancement Control Cabinet Module according to the first aspect of the present invention, device operation boundary data and/or device characteristics stored in a configuration memory of the application device connected to the application device interface are transmitted via a communication channel of the wired or wireless application device control interface to the data processing unit of the Function Enhancement Control Cabinet Module.

In a possible implementation of the Function Enhancement Control Cabinet Module, the device operation boundary data of the application device is stored at least temporarily in a data memory of the data processing unit of the Function Enhancement Control Cabinet Module.

In a possible implementation of the Function Enhancement Control Cabinet Module according to the first aspect of the present invention, the stored device operation boundary data comprises a maximum and minimum admissible supply current,
a maximum and minimum admissible supply voltage,
a maximum and minimum admissible operation temperature,
an I²t value and/or a maximum switching frequency of the connected application device.

In a further possible embodiment of the Function Enhancement Control Cabinet Module according to the first aspect of the present invention, the data processing unit of the Function Enhancement Control Cabinet Module is adapted to perform automatically a pre-configuration of possible functions of the connected application device on the basis of the application device identification data and/or on the basis of the device operation boundary data and/or on the basis of the device characteristics received by the data processing unit via a wired or wireless application device control interface.

In a further possible embodiment of the Function Enhancement Control Cabinet Module according to the first aspect of the present invention functions of the Function Enhancement Control Cabinet Module can be pre-configured or re-configured automatically depending on a detected type of the application device or depending on an input type of the application device input by a user.

These functions may comprise for instance a matching monitoring algorithm for current monitoring or a coupling of auxiliary outputs to current threshold values voltage threshold values or to temperature threshold values.

In a further possible embodiment of the Function Enhancement Control Cabinet Module according to the first aspect of the present invention, the current sensor of the measurement unit being adapted to measure the electrical current flowing in forward power supply direction or flowing in reverse power supply direction through the internal power supply path of the Function Enhancement Control Cabinet Module comprises at least one shunt resistor, a Hall sensor, a current transformer or a Rogowski coil and is adapted to provide a current sensor signal sampled and converted by a first analog to digital converter of the measurement unit to generate current measurement data supplied by the measurement unit to a data memory of the data processing unit of the Function Enhancement Control Cabinet Module and/or stored in a local non-volatile data memory of the data processing unit as a current profile.

In a further possible embodiment of the Function Enhancement Control Cabinet Module according to the first aspect of the present invention, the voltage sensor of the measurement unit is adapted to measure the electrical voltage at the internal power supply path and is adapted to provide a voltage sensor signal sampled and converted by a second analog to digital converter of the measurement unit to generate voltage measurement data supplied by the measurement unit to a data memory of the data processing unit of the Function Enhancement Control Cabinet Module and/or stored in a local non-volatile data memory of the data processing unit as a voltage profile.

In a further possible embodiment of the Function Enhancement Control Cabinet Module according to the first aspect of the present invention, the temperature sensor is adapted to measure a temperature at the internal power supply path provided within the housing of the Function Enhancement Control Cabinet Module and is adapted to provide a temperature sensor signal sampled and converted by a third analog to digital converter of the measurement unit to generate temperature measurement data supplied by the measurement unit to a data memory of the data processing unit of the Function Enhancement Control Cabinet Module and/or stored in a local non-volatile data memory of the data processing unit as a temperature profile.

In a still further possible embodiment of the Function Enhancement Control Cabinet Module according to the first aspect of the present invention, the power distribution system comprises an AC power distribution system having at least one AC power supply phase applied to a corresponding electrical contact of the energy interface provided at a rear side of the housing of the Function Enhancement Control Cabinet Module connected to the power distribution system of the control cabinet.

In a still further possible embodiment of the Function Enhancement Control Cabinet Module according to the first aspect of the present invention, the data processing unit included in the housing of the Function Enhancement Control Cabinet Module and/or the external control cabinet controller of the control cabinet being connected to the control interface of the Function Enhancement Control Cabinet Module is adapted to process the measurement data, the application device identification data and/or the device operation boundary data of the application device connected to the application device interface of the Function Enhancement Control Cabinet Module in real time to optimize an electrical power supply of the connected application device and/or to provide an overcurrent protection and/or to provide an overload protection to the connected application device or to provide an overcurrent protection and/or to provide an overload protection to a load device connected to the application device and/or to control a state of the connected application device and/or to control a state of a load device connected to the respective application device.

In a still further possible embodiment of the Function Enhancement Control Cabinet Module according to the first aspect of the present invention, the measurement data, the application device identification data and/or the device operation boundary data are recorded and stored continuously or event-driven at least temporarily in a local non-volatile data memory of the data processing unit of the Function Enhancement Control Cabinet Module. The events can comprise for instance be the result of a comparison of measurement data with predetermined threshold values. If a threshold value is exceeded this event can automatically trigger a recording and/or processing of data.

In a possible embodiment of the Function Enhancement Control Cabinet Module according to the first aspect of the present invention, a processor of the data processing unit of the Function Enhancement Control Cabinet Module is adapted to process and evaluate the stored measurement data, the stored application device identification data and/or the stored device operation state of the application device connected to the application device interface provided at a front side of the housing of the Function Enhancement Control Cabinet Module to detect or predict a failure of the connected application device and to notify an internal microcontroller or FPGA of the data processing unit or an external control cabinet controller connected to the control interface of the Function Enhancement Control Cabinet Module about the detected or predicted failure of the connected application device.

In a possible embodiment of the Function Enhancement Control Cabinet Module according to the first aspect of the present invention, the external control cabinet controller connected to the control interface of the Function Enhancement Control Cabinet Module is adapted to trigger a repair or a maintenance or a troubleshooting action to address the notified failure of the application device connected to the application device interface provided at the front side of the housing of the Function Enhancement Control Cabinet Module.

In a still further possible embodiment of the Function Enhancement Control Cabinet Module according to the first aspect of the present invention, an acquisition of measurement data, of the application device identification data and/or of the device operation boundary data is triggered by a control entity of the application device connected to the application device interface provided at a front side of the housing of the Function Enhancement Control Cabinet Module or is triggered by a microcontroller or by an FPGA of the data processing unit included in the housing of the Function Enhancement Control Cabinet Module or is triggered by the external control cabinet controller connected to the control interface of the Function Enhancement Control Cabinet Module.

In a still further possible embodiment of the Function Enhancement Control Cabinet Module according to the first aspect of the present invention, the acquired measurement data stored in the local non-volatile data memory of the data processing unit is evaluated by a processor of the data processing unit of the Function Enhancement Control Cabinet Module to determine specific data patterns representing associated application device operation states of the at least one application device connected to the application device interface provided at the front side of the housing of the Function Enhancement Control Cabinet Module and/or representing associated power supply states of the power distribution system of the control cabinet connected to the energy interface provided at the rear side of the housing of the Function Enhancement Control Cabinet Module.

In a still further possible embodiment of the Function Enhancement Control Cabinet Module according to the first aspect of the present invention, the data processing unit of the Function Enhancement Control Cabinet Module comprises a trained artificial neural network adapted to recognize application device operation states of the application device connected to the application device interface provided at the front side of the housing of the Function Enhancement Control Cabinet Module and/or to recognize power supply operation states of the power distribution system of the control cabinet connected to the energy interface provided at the rear side of the housing of the Function Enhancement Control Cabinet Module on the basis of measurement data received by the artificial neural network of the data processing unit from the galvanically isolated measurement unit of the Function Enhancement Control Cabinet Module or read from a local non-volatile data memory of the data processing unit and applied to an input layer of the trained artificial neural network of the data processing unit to provide a classification result output by an output layer of the trained artificial neural network to a microcontroller or FPGA of the data processing unit.

In a still further possible embodiment of the Function Enhancement Control Cabinet Module according to the first aspect of the present invention, the data processing unit of the Function Enhancement Control Cabinet Module is adapted to communicate with the external control cabinet controller of the control cabinet connected to the control interface of the Function Enhancement Control Cabinet Module by means of a predefined data transfer protocol including a field bus data transfer protocol or an Ethernet-based data transfer protocol.

In a still further possible embodiment of the Function Enhancement Control Cabinet Module according to the first aspect of the present invention, the application device connected to the application device interface provided at the front side of the housing of the Function Enhancement Control Cabinet Module comprises a switchable or a non-switchable load connector. The switching can be performed manually or electrically controlled.

In a still further possible embodiment of the Function Enhancement Control Cabinet Module according to the first aspect of the present invention, the application device connected to the application device interface provided at the front side of the housing of the Function Enhancement Control Cabinet Module comprises a meltable or an electronic-controlled fuse element.

In a further possible embodiment of the Function Enhancement Control Cabinet Module according to the first aspect of the present invention, the energy interface provided at the rear side of the housing of the Function Enhancement Control Cabinet Module comprises several electrical contacts for AC power supply phases of a multiphase power distribution system.

In a further possible embodiment of the Function Enhancement Control Cabinet Module according to the first aspect of the present invention, the application device interface provided at the front side of the housing of the Function Enhancement Control Cabinet Module comprises several electrical contacts for AC power supply phases of a multiphase application device connectable to the application device interface provided at the front side of the housing of the Function Enhancement Control Cabinet Module.

In a further possible embodiment of the Function Enhancement Control Cabinet Module according to the first aspect of the present invention, a processor of the data processing unit is adapted to calculate a phase relationship between different electrical AC power supply phases supplied via the bidirectional internal power supply path of the Function Enhancement Control Cabinet Module and/or to determine a frequency of the electrical AC power supply phases based on the measurement data received by the data processing unit from the measurement unit of the Function Enhancement Control Cabinet Module and/or based on measurement data stored in a data memory of the data processing unit.

In a still further possible embodiment of the Function Enhancement Control Cabinet Module according to the first aspect of the present invention, the processor of the data processing unit is further adapted to calculate a real power, a reactive power and/or an apparent power of each phase of the multiphase power distribution system and to calculate summed real, reactive and apparent power values of the multiphase power distribution system, and/or to accumulate energy values related to single phases or related to multiple phases of the multiphase power distribution system.

In a still further possible embodiment of the Function Enhancement Control Cabinet Module according to the first aspect of the present invention, the measurement unit of the Function Enhancement Control Cabinet Module is integrated in a measurement submodule connected via an internal data and control interface to the data processing unit of the Function Enhancement Control Cabinet Module integrated in a separate data processing submodule.

In a further possible embodiment of the Function Enhancement Control Cabinet Module according to the first aspect of the present invention, the measurement submodule is connectable to the data processing submodule via the internal data and control interface to provide the Function Enhancement Control Cabinet Module.

In a still further possible embodiment of the Function Enhancement Control Cabinet Module according to the first aspect of the present invention, the data processing unit is adapted to perform an automatic rotation field detection and/or to perform an automatic polarity detection based on the measurement data received from the measurement unit or stored in the data memory and/or based on the phase relationship between different electrical AC power supply phases calculated by the processor of the data processing unit.

In a further possible embodiment of the Function Enhancement Control Cabinet Module according to the first aspect of the present invention, the data processing unit of the Function Enhancement Control Cabinet Module comprises a microcontroller or an FPGA adapted to control at least one actuator provided in the bidirectional internal power supply path of the Function Enhancement Control Cabinet Module or provided at the application device in response to the measurement data received by the data processing unit from the measurement unit of the Function Enhancement Control Cabinet Module or read from the data memory to optimize the power supply of the connected application device and/or to provide protection of the application device or its connected load device against overcurrent and/or against overload.

In a still further possible embodiment of the Function Enhancement Control Cabinet Module according to the first aspect of the present invention, the actuator comprises a controllable semiconductor power switch or comprises an electromechanical power switch.

In a further possible embodiment of the Function Enhancement Control Cabinet Module according to the first aspect of the present invention, a microcontroller or FPGA of the data processing unit is adapted to control functions of the application device connected to the application device interface provided at a front side of the housing of the Function Enhancement Control Cabinet Module through an application device control interface of the Function Enhancement Control Cabinet Module.

In a further possible embodiment of the Function Enhancement Control Cabinet Module according to the first aspect of the present invention, measurement data supplied by a measurement unit of the Function Enhancement Control Cabinet Module to a processor or to an FPGA of the data processing unit of the Function Enhancement Control Cabinet Module and/or stored in a local non-volatile data memory of the data processing unit and/or failure messages indicating a failure of the Function Enhancement Control Cabinet Module and/or indicating a failure of an application device connected to the application device interface of the Function Enhancement Control Cabinet Module are forwarded to the external control cabinet controller connected to the control interface of the Function Enhancement Control Cabinet Module along with a unique identifier of the Function Enhancement Control Cabinet Module and/or along with information indicating a mounting position of the affected Function Enhancement Control Cabinet Module within the respective control cabinet.

In a further possible embodiment of the Function Enhancement Control Cabinet Module according to the first aspect of the present invention, the control cabinet controller of the control cabinet is adapted to compare the measurement data received by the control cabinet controller via control interfaces from different Function Enhancement Control Cabinet Modules mounted in the control cabinet to identify a deviating operation behavior of a Function Enhancement Control Cabinet Module.

In a possible embodiment, the Function Enhancement Control Cabinet Module is connected to an internal power distribution busbar system of a control cabinet.

The invention provides according to a further aspect a Function Enhancement Control Cabinet Busbar Module comprising at least one internal bidirectional power supply path provided between an energy interface at a rear side of a housing of the Function Enhancement Control Cabinet Busbar Module and the application device interface provided at a front side of the housing of the Function Enhancement Control Cabinet Busbar Module and adapted to feed electrical power in a forward power supply direction from at least one busbar of a power distribution busbar system connected to the energy interface to the application device connected to the application device interface or is adapted to feed electrical power in a reverse power supply direction from the application device connected to the application device interface to at least one busbar of the power distribution busbar system connected to the energy interface and comprising at least one measurement unit integrated in the housing of the Function Enhancement Control Cabinet Busbar Module and provided at the internal power supply path between the energy interface and the application device interface to provide measurement data to a data processing unit integrated in the housing of the Function Enhancement Control Cabinet Busbar Module, wherein said data processing unit is galvanically isolated from said measurement unit and is adapted to exchange control information and data with an external control cabinet controller of a control cabinet connected to a control interface of the Function Enhancement Control Cabinet Busbar Module provided in the housing of the Function Enhancement Control Cabinet Busbar Module and connected to the integrated data processing unit of the Function Enhancement Control Cabinet Busbar Module.

In a possible embodiment of the Function Enhancement Control Cabinet Busbar Module, the power distribution busbar system of the control cabinet comprises an AC power distribution busbar system having at least one busbar for an associated power supply phase applied to a corresponding electrical contact of the energy interface provided at a rear side of the housing of the Function Enhancement Control Cabinet Busbar Module connected to the power distribution busbar system.

In an alternative embodiment, the Function Enhancement Control Cabinet Busbar Module comprises a DC power distribution busbar system providing a DC power supply applied to at least one busbar of the DC power supply system.

In a further possible embodiment of the Function Enhancement Control Cabinet Busbar Module according to the second aspect of the present invention, the application device connected to the application device interface provided at the front side of the housing of the Function Enhancement Control Cabinet Busbar Module comprises an electrical load including a resistive load, a capacitive load and/or an inductive load or comprises an adapter device used for connection of a load device.

In a further possible embodiment of the Function Enhancement Control Cabinet Busbar Module according to the second aspect of the present invention, the energy interface provided at the rear side of the housing of the Function Enhancement Control Cabinet Busbar Module comprises electrical contacts protruding from the rear side of the housing of the Function Enhancement Control Cabinet Busbar Module pluggable into corresponding slots of busbars of the power distribution busbar system of the control cabinet.

The busbars of the power distribution system can in a possible embodiment be integrated in a touch protected busbar board.

In a still further possible embodiment of the Function Enhancement Control Cabinet Busbar Module according to the second aspect of the present invention, the application device interface provided at the front side of the housing of the Function Enhancement Control Cabinet Busbar Module comprises at least one busbar portion of an internal busbar included in the housing of the Function Enhancement Control Cabinet Busbar Module and forming part of the internal bidirectional power supply path, wherein the busbar portion of the internal busbar comprises slots into which protruding electrical contacts of an application device are pluggable through associated contact openings provided at the front side of the housing of the Function Enhancement Control Cabinet Busbar Module.

In a still further possible embodiment of the Function Enhancement Control Cabinet Busbar Module according to the second aspect of the present invention, the measurement unit and the data processing unit integrated in the electrically isolating housing of the Function Enhancement Control Cabinet Busbar Module are provided on a printed circuit board surrounded by the electrically isolating housing of the Function Enhancement Control Cabinet Busbar Module.

In a possible embodiment the Printed Circuit Board is replaceable.

In a further possible embodiment of the Function Enhancement Control Cabinet Busbar Module according to the second aspect of the present invention, the sensors of the measurement unit of the Function Enhancement Control Cabinet Busbar Module are provided at the at least one internal busbar included in the housing of the Function Enhancement Control Cabinet Busbar Module to provide measurement data to the data processing unit of the Function Enhancement Control Cabinet Busbar Module indicating an amplitude or an amplitude change of an electrical current flowing through the internal busbar and/or indicating an electrical voltage or voltage change of an electrical voltage at the internal busbar of the Function Enhancement Control Cabinet Busbar Module.

In a possible embodiment of the Function Enhancement Control Cabinet Busbar Module, an auxiliary power supply for the data processing unit of the Function Enhancement Control Cabinet Busbar Module is provided through the control interface of the Function Enhancement Control Cabinet Busbar Module.

In a further possible embodiment of the Function Enhancement Control Cabinet Busbar Module according to the second aspect of the present invention, for each AC power supply phase of a multiphase AC power distribution busbar system of the control cabinet, a separate Function Enhancement Control Cabinet Busbar Module is provided.

In a still further possible embodiment of the Function Enhancement Control Cabinet Busbar Module according to the second aspect of the present invention, a sensor provided at the internal power supply path is adapted to generate a sensor signal supplied via gold spring elements to the data processing unit mounted on a printed circuit board of the Function Enhancement Control Cabinet Busbar Module.

In a further possible embodiment of the Function Enhancement Control Cabinet Busbar Module according to the second aspect of the present invention, the user visualization interface comprises a set of light emitting diodes located at the application device interface and adapted to indicate a connection state and/or an operation state of an application device connected to the application device interface of the Function Enhancement Control Cabinet Busbar Module and comprises a set of light emitting diodes, located at the energy supply interface and adapted to indicate a connection state and/or an operation state of the power distribution busbar system of the control cabinet connected to the energy supply interface of the Function Enhancement Control Cabinet Busbar Module.

In a still further possible embodiment of the Function Enhancement Control Cabinet Busbar Module according to the second aspect of the present invention, the application device connected to the application device interface provided at the front side of the housing of the Function Enhancement Control Cabinet Busbar Module comprises an RFID tag storing application device identification data and/or device operation boundary data read by an RFID reading unit of the Function Enhancement Control Cabinet Busbar Module and supplied to a processor of the data processing unit of the Function Enhancement Control Cabinet Busbar Module and/or stored in a local non-volatile data memory of the data processing unit.

The invention provides according to a further third aspect a control cabinet including one or more Function Enhancement Control Cabinet Modules according to the first or second aspect of the present invention.

The invention provides according to the third aspect a control cabinet including one or more Function Enhancement Control Cabinet Modules according to the first or second aspect of the present invention being mounted in the control cabinet, wherein the Function Enhancement Control Cabinet Module comprises an energy interface connected to an AC power distribution system or to a DC power distribution system of the control cabinet and comprises an application device interface for connection of at least one application device via a bidirectional internal power supply path of the Function Enhancement Control Cabinet Module to the AC or DC power distribution system of the control cabinet and further comprises a control interface provided for connection of the respective Function Enhancement Control Cabinet Module to a control cabinet controller of the control cabinet, wherein the Function Enhancement Control Cabinet Modules of the control cabinet are adapted to communicate with each other and/or to communicate with the control cabinet controller of the control cabinet by means of wired or wireless communication interfaces.

In a possible embodiment of the control cabinet according to the third aspect of the present invention, busbars of the power distribution busbar system of the control cabinet are encapsulated by a touch protection busbar board having slots to receive protruding electrical contacts of the energy interface of the Function Enhancement Control Cabinet Module being pluggable through contact openings provided at the front side of the touch protection busbar board into corresponding slots of the encapsulated busbars of the power distribution busbar system of the control cabinet lying directly beneath the contact openings of the respective touch-protected busbar board.

In a possible embodiment of the control cabinet according to the third aspect of the present invention, the busbars of the power distribution busbar system of the control cabinet are mounted in a horizontal direction within the control cabinet.

The busbars of the power distribution busbar system of the control cabinet can be mounted on a mounting platform of the control cabinet, wherein the mounting platform comprises a mounting plate or mounting support poles of the control cabinet.

In a further possible embodiment of the control cabinet according to the third aspect of the present invention, a multiphase application device having protruding electrical contacts is pluggable through corresponding contact openings provided at the front side of the housing of the multiphase Function Enhancement Control Cabinet Module into slots of internal busbars included in the housing of the multiphase Function Enhancement Control Cabinet Module to establish an electrical contact via the bidirectional internal power supply path of the multiphase Function Enhancement Control Cabinet Module with the electrical contacts of the energy interface provided at the rear side of the housing of the multiphase Function Enhancement Control Cabinet Module and for establishing an electrical connection with the busbars of the power distribution busbar system of the respective control cabinet.

In a possible embodiment of the control cabinet according to the third aspect of the present invention, the multiphase Function Enhancement Control Cabinet Module mounted in the control cabinet comprises for each AC power supply phase of the multiphase AC power distribution busbar system an associated measurement unit and a corresponding data processing unit.

In a possible embodiment of the control cabinet according to the third aspect of the present invention, the data processing units of a multiphase Function Enhancement Control Cabinet Module are provided on a common rectangular printed circuit board being enclosed by an elongated housing of the multiphase Function Enhancement Control Cabinet Module and being oriented perpendicular to the busbars on mounting rails of the multiphase power distribution busbar system of the control cabinet.

In a further possible embodiment of the control cabinet according to the third aspect of the present invention, the control cabinet controller of the control cabinet is connected to a user interface of the control cabinet adapted to display operation states and/or to display a predicted or detected failure of a plurality of application devices connected to the Function Enhancement Control Cabinet Modules included in a housing of the control cabinet.

In a further possible embodiment of the control cabinet according to the third aspect of the present invention, the rear side of the housing of the Function Enhancement Control Cabinet Module is mountable to a rail or a mounting plate of the respective control cabinet.

In the following, possible embodiments of the different aspects of the present invention are described in more detail with reference to the enclosed figures.
- Fig. 1: shows a block diagram of a possible exemplary embodiment of a Function Enhancement Control Cabinet Module according to an aspect of the present invention;
- Fig. 2: shows a schematic diagram for illustrating different connection systems used in a control cabinet according to an aspect of the present invention;
- Fig. 3: shows a further schematic block diagram for illustrating a possible exemplary embodiment of a Function Enhancement Control Cabinet Module according to an aspect of the present invention;
- Fig. 4: shows a further block diagram for illustrating a possible exemplary embodiment of a Function Enhancement Control Cabinet Module according to the present invention;
- Figs. 5A, 5B, 5C: illustrate possible exemplary implementations of a measurement unit provided within a Function Enhancement Control Cabinet Module according to the present invention;
- Fig. 6: shows a further block diagram for illustrating a possible exemplary embodiment of a Function Enhancement Control Cabinet Module according to the present invention;
- Fig. 7: shows a further schematic block diagram for illustrating a possible exemplary embodiment of a control cabinet according to a further aspect of the present invention;
- Fig. 8: shows a further block diagram for illustrating a possible exemplary embodiment of an automation system comprising control cabinets according to the present invention;
- Fig. 9: shows schematically a possible embodiment of an automation system including several control cabinets;
- Fig. 10: shows a block diagram for illustrating a multiphase Function Enhancement Control Cabinet Module according to the present invention;
- Fig. 11: shows a perspective view illustrating the assembly of an application device to an application device interface provided on a front side of a Function Enhancement Control Cabinet Module according to the present invention mounted to busbars of a power distribution system of a control cabinet;
- Fig. 12: shows a further perspective view for illustrating the assembly of a load device to an application device connected to a Function Enhancement Control Cabinet Module mounted to busbars of a power distribution system of the control cabinet;
- Fig. 13: shows a schematic cross-sectional view for illustrating a possible exemplary embodiment of a Function Enhancement Control Cabinet Module according to the present invention;
- Figs. 14A, 14B: illustrate a possible implementation of a Function Enhancement Control Cabinet Module according to the present invention;
- Fig. 15: illustrates a printed circuit board with mounted internal busbars provided within a housing of a multiphase Function Enhancement Control Cabinet Module according to the present invention;
- Fig. 16: illustrates a printed circuit board provided within a housing of a multiphase Function Enhancement Control Cabinet Module according to the present invention;
- Fig. 17: illustrates an exemplary implementation of a measurement unit within a housing of a Function Enhancement Control Cabinet Module according to the present invention;
- Figs. 18A, 18B: illustrate possible variants for mounting a Function Enhancement Control Cabinet Module to a busbar of a power distribution system of the control cabinet;
- Fig. 19: illustrates a further variant for mounting a Function Enhancement Control Cabinet Module according to the present invention to a mounting rail of a control cabinet;
- Fig. 20A,20B: illustrate a forward supply direction and a reverse power supply direction of a Function Enhancement Control Cabinet according to the present invention:
- Fig. 21: illustrates the power supply of a load device by a local power supply generation source through Function Enhancement Control Cabinet Modules connected to busbars of a power distribution system of a control cabinet;
- Figs. 22A, 22B: illustrate a possible exemplary embodiment of a turnable housing of a Function Enhancement Control Cabinet Module according to the present invention;
- Fig. 23: illustrates a composition of a multiphase Function Enhancement Control Cabinet Module from several single phase Function Enhancement Control Cabinet Modules;
- Fig. 24: illustrates a possible stacking of multiple Function Enhancement Control Cabinet Modules according to the present invention between a power distribution system of a control cabinet and an application device used for connection of load or power generation devices;
- Fig. 25: illustrates a possible exemplary embodiment of a Function Enhancement Control Cabinet Module with a replaceable printed circuit board;
- Fig. 26: illustrates a further exemplary embodiment of a Function Enhancement Control Cabinet Module using a communication busbar for communication;
- Figs. 27A, 27B: illustrate a Function Enhancement Control Cabinet Module sandwiched between a power distribution system and an application device which comprises an unfoldable graphical user interface.
- Fig. 28: shows a perspective view on a busbar board of a power distribution system with several application devices mounted on a front face of the busbar via sandwiched Function Enhancement Control Cabinet Modules according to the present invention.

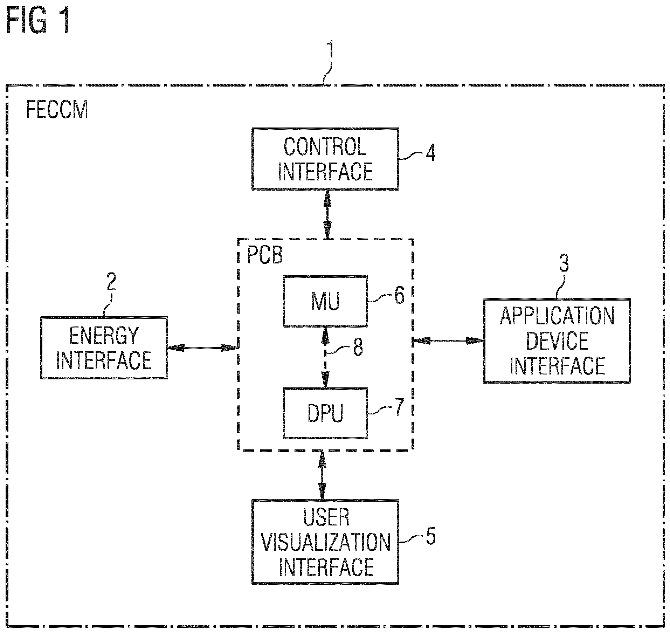

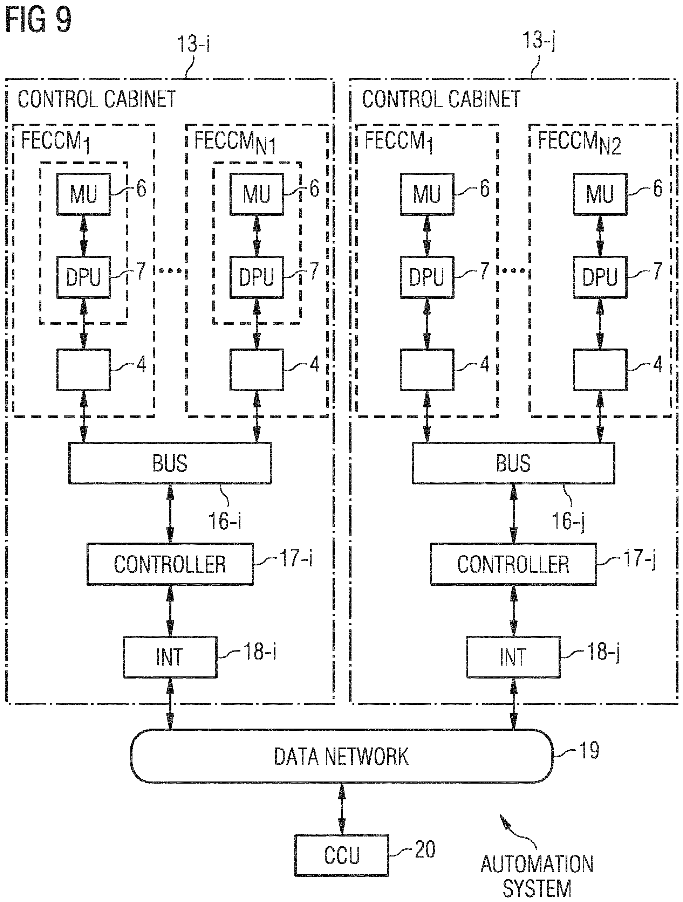

Fig. 1 shows a block diagram of a Function Enhancement Control Cabinet Module 1 for a control cabinet 13 according to a first aspect of the present invention as shown in Fig. 9.

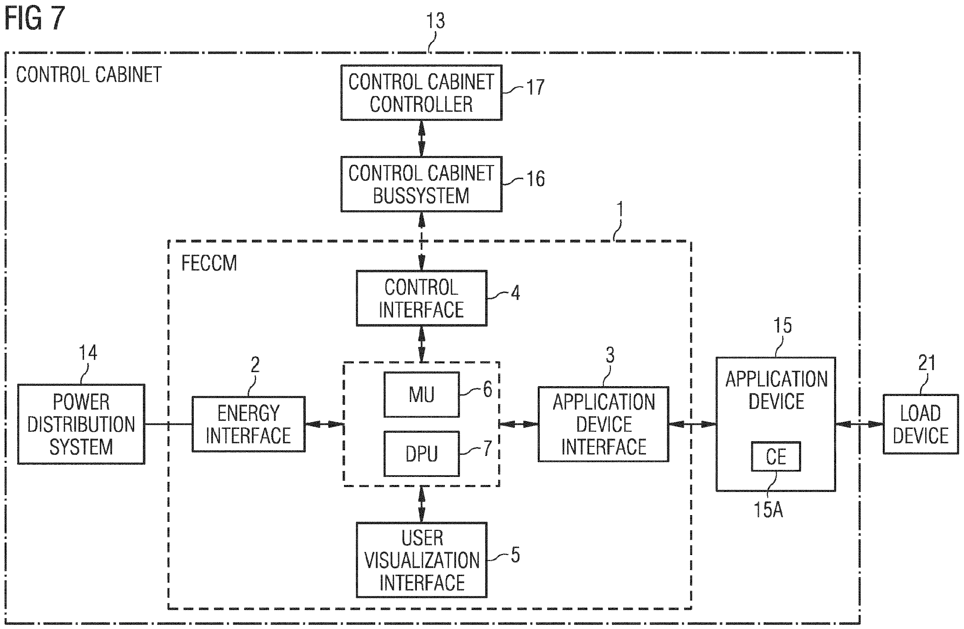

The Function Enhancement Control Cabinet Module 1 illustrated in Fig. 1 can be mounted to a mounting platform of a control cabinet 13. In the illustrated embodiment illustrated in Fig. 1, the Function Enhancement Control Cabinet Module 1 comprises at least one energy interface 2 used for connection of said Function Enhancement Control Cabinet Module 1 to a power distribution system 14 of the control cabinet 13. The energy interface 2 as shown in Fig. 1 is provided in a preferred embodiment on a rear side of a housing of the Function Enhancement Control Cabinet Module 1, i.e. facing the mounting platform of the control cabinet 13 also shown in Fig. 7.

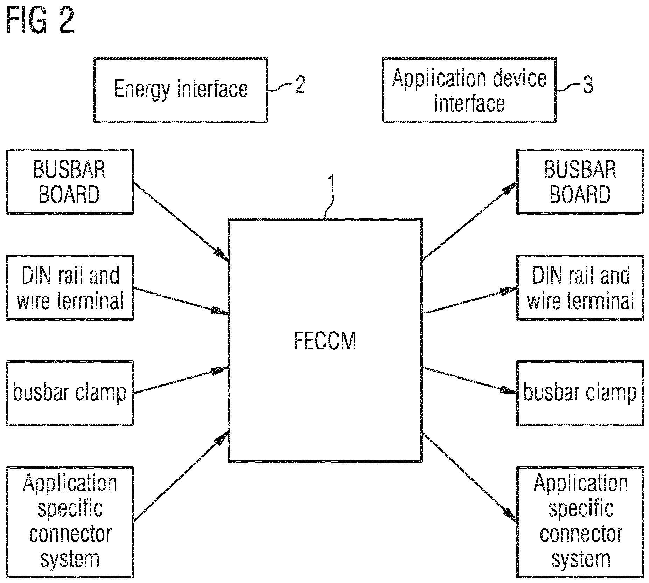

The Function Enhancement Control Cabinet Module 1 further comprises at least one application device interface 3 for connection and power supply of at least one application device 15 to the Function Enhancement Control Cabinet Module 1. The application device interface 3 as shown in Fig. 2 is provided in a preferred embodiment on a front side of the housing of the Function Enhancement Control Cabinet Module 1, i.e. facing to the front side of the control cabinet 13 and accessible to a user of the control cabinet 13.

The Function Enhancement Control Cabinet Module 1 further comprises in the illustrated embodiment of Fig. 1 a control interface 4 for connection of the Function Enhancement Control Cabinet Module 1 to a control cabinet controller 17 of the respective control cabinet 13 as also shown in Fig. 7.

The Function Enhancement Control Cabinet Module 1 according to the present invention comprises further in a possible embodiment a user visualization interface 5 as shown in Fig. 1 adapted to provide output information to a user and/or to receive user input commands from a user of the control cabinet 13.

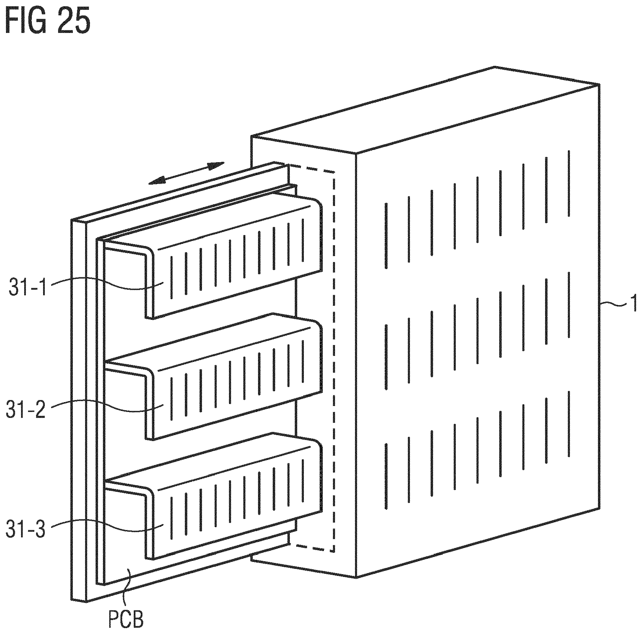

As can be seen in the block diagram of Fig. 1, the different interfaces of the Function Enhancement Control Cabinet Module 1, i.e. the energy interface 2, the application device interface 3, the control interface 4 and the user visualization interface 5 are connected to an internal electronic circuitry provided on a printed circuit board PCB of the Function Enhancement Control Cabinet Module 1. This printed circuit board PCB is either integrated and unreplaceable mounted within the housing of the Function Enhancement Control Cabinet Module 1 or can be replaced by a substitute printed circuit board PCB as illustrated in Fig.25.

The internal circuitry of the Function Enhancement Control Cabinet Module 1 comprises at least one measurement unit 6 provided between the energy interface 2 and the application device interface 3 to provide measurement data MDATA for a data processing unit 7 of the Function Enhancement Control Cabinet Module 1. The data processing unit 7 is galvanically isolated from the measurement unit 6. The data processing unit 7 is further adapted to exchange control information and data via the control cabinet controller 17 of the control cabinet 13 connected to the control interface 4 of the Function Enhancement Control Cabinet Module 1.

The control cabinet controller or control device 17 can for instance comprise a PLC or PC system. In a possible implementation, also auxiliary energy can be supplied to the internal circuitry mounted on a printed circuit board PCB of the Function Enhancement Control Cabinet Module 1 via the control interface 4. The energy interface 2 can be connected to an internal power distribution system 14 of the control cabinet 13.

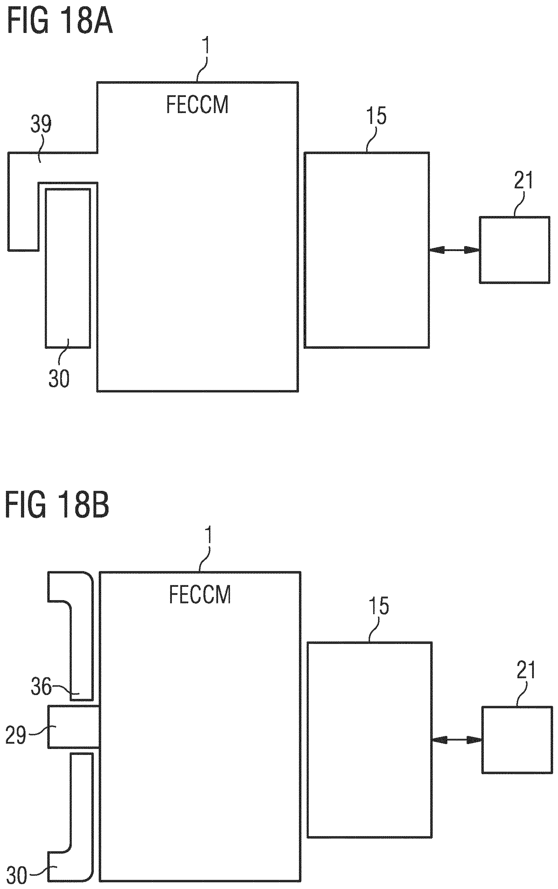

Fig. 2 shows schematically different connection or assembly systems which can be used for connection of the Function Enhancement Control Cabinet Module 1. In a preferred embodiment, the energy interface 2 is provided at a rear side of a housing of the Function Enhancement Control Cabinet Module 1. On the opposite front side of the Function Enhancement Control Cabinet Module 1 at least one application device interface 3 is provided and accessible by a user U for mounting at least one application device 15 to the front side of the housing of the Function Enhancement Control Cabinet Module 1. The Function Enhancement Control Cabinet Module 1 is mounted on a mounting platform of the control cabinet 13. The mounting platform can comprise a mounting plate or a mounting support bar system. The rear side of the housing of the Function Enhancement Control Cabinet Module 1 can be mounted, for instance, on a mounting rail such as a DIN rail and receive electrical power from the local power distribution system 14 via terminals of the energy interface 2. In an alternative embodiment, the energy interface 2 comprises contacts which can be plugged into corresponding slots of busbars 30 of a busbar power supply or power distribution system 14 of the control cabinet 13 as also shown in Fig. 18B. These busbars 30 are in a preferred embodiment touch-protected and can be integrated in a possible implementation in an elongated isolated busbar board. In a further alternative implementation, the electrical contacts of the energy interface 2 can also be snapped or clipped by means of hooking elements 39 behind conventional busbars 30 of a power supply busbar system 14 comprising massive busbars as also illustrated in Fig. 18A. Any other application-specific connector system for mounting the housing of the Function Enhancement Control Cabinet Module 1 to the mounting platform of the control cabinet 13 can be used as well.

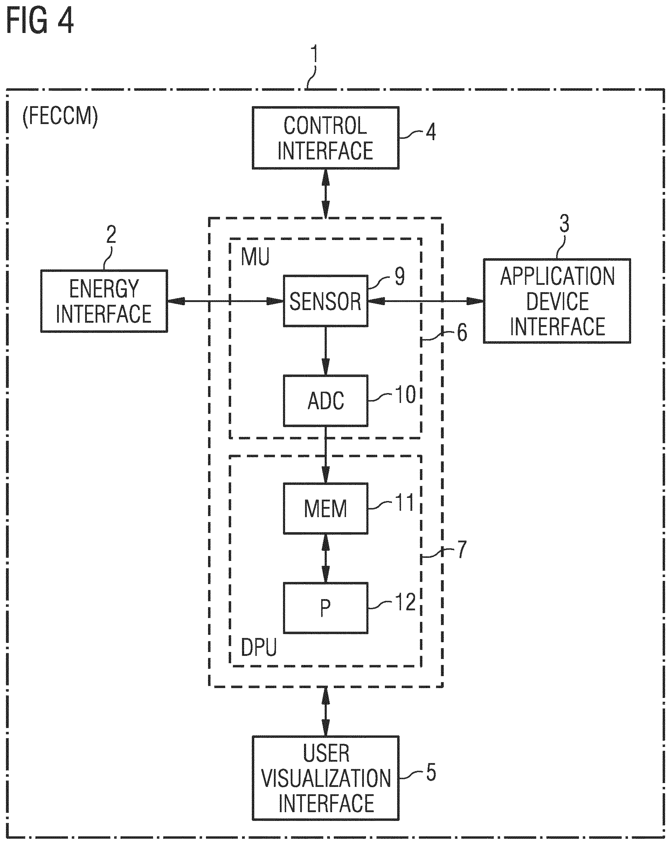

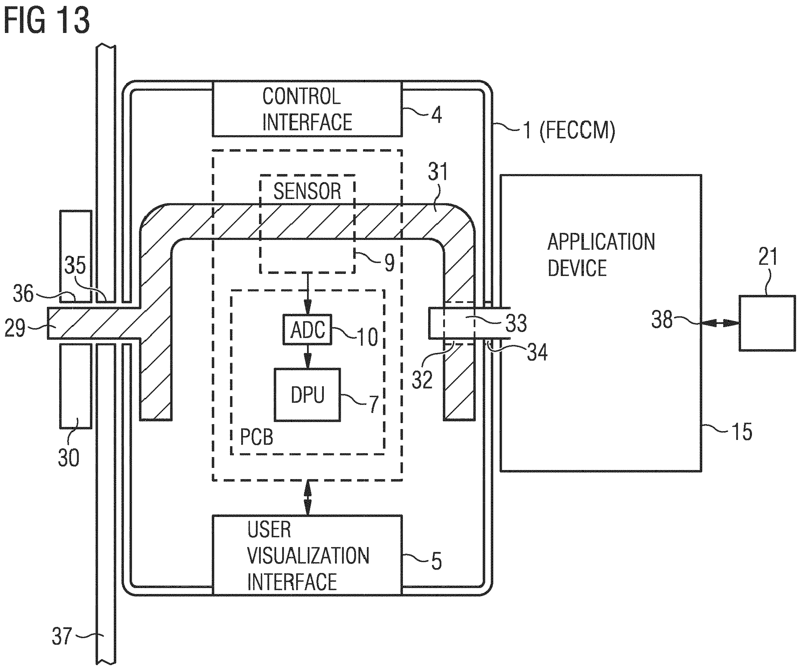

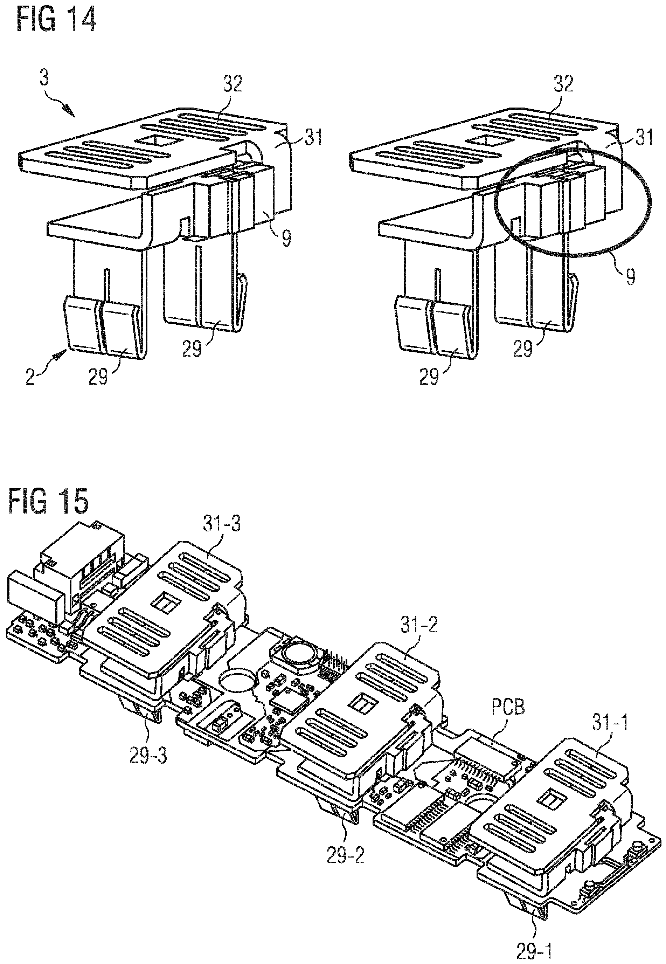

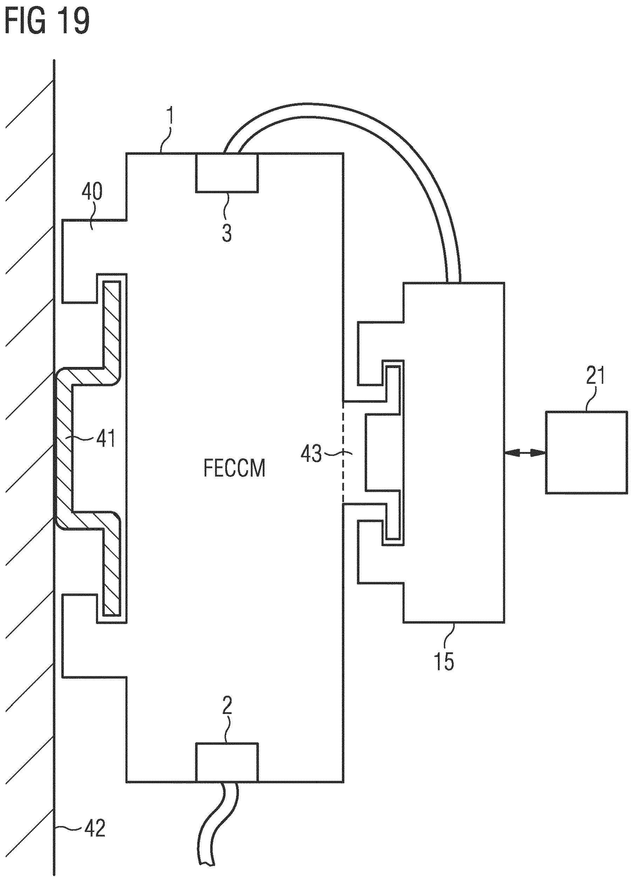

Also, on the front side of the housing of the Function Enhancement Control Cabinet Module 1, there can be different ways to connect an application device 15 to the application device interface 3 of the Function Enhancement Control Cabinet Module 1. For instance, the application device interface 3 can comprise internal busbars 31 having slots 32 for receiving protruding electrical contacts 33 of application devices 15 connected to the respective contacts of the application device interface 3 as also illustrated in Fig. 13 and Fig.14. Further, at the front side of the housing of the Function Enhancement Control Cabinet Module 1, also mounting rails 43 can be provided to connect application devices 15 to the front face of the housing of the Function Enhancement Control Cabinet Module 1 and connecting them electrically via conventional wires to the application device interface 3 as also shown in Fig. 19. Other application-specific connector systems for mounting and connecting the application devices 15 to the at least one application device interface 3 of the Function Enhancement Control Cabinet Module 1 can be used as well. The provision of different connector systems for connecting the Function Enhancement Control Cabinet Module 1 to the power distribution system 14 of the control cabinet 13 increases the flexibility of using the Function Enhancement Control Cabinet Module 1 according to the present invention. Further, the different application-specific connector systems provided at the front side of the housing of the Function Enhancement Control Cabinet Module 1 used for connecting different kinds of application devices 15 to the application device interface 3 provides additional flexibility and allows the use of a wide variety of different kinds of application devices 15 for connection to the Function Enhancement Control Cabinet Module 1 according to the present invention. The energy interface 2 and the application device interface 3 are provided on opposite sides of the housing of the Function Enhancement Control Cabinet Module 1. The energy interface 2 and the application device interface 3 are connected via a bidirectional internal power supply path PSP as also illustrated schematically in Fig. 4.

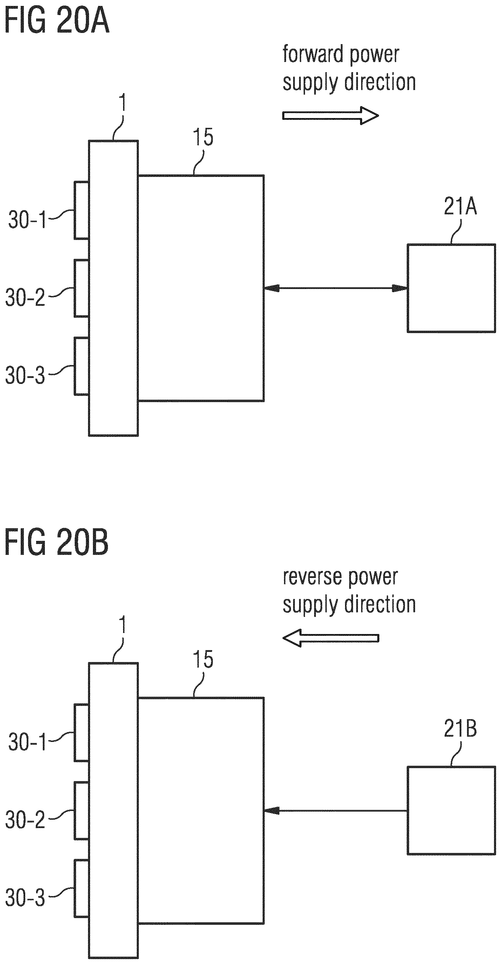

The internal bidirectional power supply path PSP is provided between the energy interface 3 at the rear side of the housing of the Function Enhancement Control Cabinet Module 1 and the application device interface 3 at the opposite front side of the housing of the Function Enhancement Control Cabinet Module 1. The internal bidirectional power supply path PSP is adapted to feed electrical power from the power distribution system 14 connected to the energy interface 2 provided at the rear side of the housing of the Function Enhancement Control Cabinet Module 1 in a forward power supply direction through the application device 15 to a load device 21A connected to the application device interface 3 provided at the front side of the housing of the Function Enhancement Control Cabinet Module 1 as shown in Fig. 20A. The bidirectional internal power supply path PSP is further adapted to feed electrical power in a reverse power supply direction from a power generation device 21B through the application device 15 connected to the application device interface 3 provided at the front side of the housing of the Function Enhancement Control Cabinet Module 1 back to the power distribution system 14 of the control cabinet 13 connected to the energy interface 2 provided at the rear side of the housing of the Function Enhancement Control Cabinet Module 1 as shown in Fig. 20B. Accordingly, the energy interface 2 and the application device interface 3 provide no predefined power supply flow direction.

The application device interface 3 is adapted to provide electrical connection to different kinds of application devices 15 or application device adapters. For instance, the application device 15 connected to the application device interface 3 can comprise a motor controller, a load switch or a fuse holder. The application device 15 connected to the application device interface 3 can also comprise for instance a power feeding element, a frequency inverter or a contactor device. The application device 15 connected to the application device interface 3 can also comprise a power supply control apparatus and/or a power supply protection apparatus providing protection to an electrical load device 21A connected to the application device 15. For instance, an inductive load 21A such as an electrical motor can be connected to an application device 15 being in turn connected to the application device interface 3 on the front side of the housing of the Function Enhancement Control Cabinet Module 1. The motor controller or motor starter forming an application device 15 can be used to control the power supply to the motor load device 21A connected to the application device 15. The Function Enhancement Control Cabinet Module 1 as shown in the block diagram of Fig. 1 is provided to generate measurement data MDATA to draw conclusions about the operation state of the application device 15 such as the motor controller and/or about the operation state of the load device 21A, i.e. the electrical motor drawing a power supply from the motor controller through the power supply path PSP of the Function Enhancement Control Cabinet Module 1.

In most use cases, the electrical power supply flows in forward power supply direction from the internal power distribution system 14 of the control cabinet 13 through the energy interface 2, the internal power supply path PSP, the application device interface 3, through the application device 15 into the power-consuming load device 21A connected to the application device 15 as shown in Fig. 20A. In some use cases, the application device 15 can also be connected to power-generating devices 21B such as batteries which are adapted to provide electrical power which can be transported in reverse power supply direction from the power source device 21B through the application device 15 and the application device interface 3 via the power supply path PSP of the Function Enhancement Control Cabinet Module 1 and via the energy interface 2 back into the power distribution system 14 of the control cabinet 13 as illustrated in Fig. 20B. The power generating device 21B can also comprise an AC current generator or another kind of AC power supply feed-in device being e.g. connected to an AC power supply grid.

In a preferred embodiment, the Function Enhancement Control Cabinet Module 1 also comprises means to switch between a forward power supply direction shown in Fig.20A and a reverse power supply direction shown in Fig.20B, for instance depending on the type of the electrical load device 21A or source device 21B connected to the application device 15 mounted to the application device interface 3 on the front side of the housing of the Function Enhancement Control Cabinet Module 1.

In a possible embodiment, switching between the forward power supply direction and the reverse power supply direction can be performed by switches under control of a microcontroller 23 integrated in the data processing unit 7 of the Function Enhancement Control Cabinet Module 1.

In a possible embodiment, an energy flow in the forward power supply direction and in the reverse power supply direction can be monitored under control of a microcontroller 23 integrated in the data processing unit 7 of the Function Enhancement Control Cabinet Module 1. For instance in a building with renewable power sources such as photovoltaic modules connected through inverters to a local power supply grid or having motors with reverse power feeding capabilities or generators the energy flow, in particular its energy flow direction, can change continuously. A change of the energy flow can be observed by sensors of the Function Enhancement Control Cabinet Module 1 and notified to a user.

In a possible implementation, the user visualization interface 5 can comprise display means to display whether electrical power is flowing in the forward power supply direction as shown in Fig. 20A or is flowing in the reverse power supply direction as shown in Fig. 20B through the power supply path PSP of the Function Enhancement Control Cabinet Module 1.

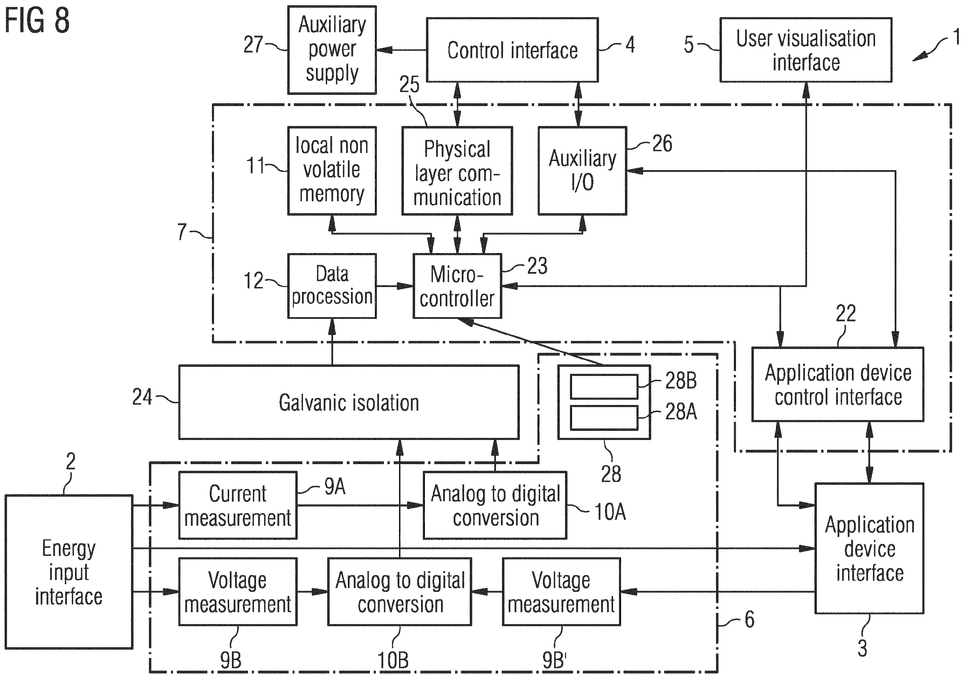

The measurement unit 6 as illustrated in Fig. 1 and included in the housing of the Function Enhancement Control Cabinet Module 1 can comprise at least one sensor element 9. In a possible embodiment, the measurement unit 6 comprises a current sensor 9A adapted to measure an electrical current I flowing through the power supply path PSP and at least one voltage sensor 9B adapted to measure an electrical voltage V at the energy interface 2 provided at the rear side of the housing of the Function Enhancement Control Cabinet Module 1 and/or to measure an electrical voltage V at the application device interface 3 provided at the front side of the housing of the Function Enhancement Control Cabinet Module 1. In a possible implementation, the Function Enhancement Control Cabinet Module 1 may also comprise at least one temperature sensor 28A (shown in Fig. 8) adapted to measure a temperature T inside the housing of the Function Enhancement Control Cabinet Module 1 and to provide the galvanically isolated data processing unit 7 of the Function Enhancement Control Cabinet Module 1 with corresponding measurement data T-MDATA. The measurement data MDATA received from the different sensors 9A, 9B, 28A of the measurement unit 6 can be stored in a memory 11 of the data processing unit 7 at least temporarily.

An application device operation state of the at least one application device 15 connected to the application device interface 3 provided at the front side of the housing of the Function Enhancement Control Cabinet Module 1 and/or an operation state of a load device 21A or a power source 21B connected to the application device 15 can be determined in a possible embodiment by the data processing unit 7 of the Function Enhancement Control Cabinet Module 1 by performing an evaluation of the stored measurement data MDATA received by the data processing unit 7 from the associated measurement unit 6 of the Function Enhancement Control Cabinet Module 1. In a possible embodiment, the application device operation state and/or the operation state of the load device 21A or power source 21B can be notified to the data processing unit 7 of the Function Enhancement Control Cabinet Module 1 through a communication link by a control entity 15A of the application device 15 connected to the application device interface 3 of the Function Enhancement Control Cabinet Module 1. Further, a power supply state of the power distribution system 14 of the control cabinet 13 being connected to the energy interface 2 provided at the rear side of the housing of the Function Enhancement Control Cabinet Module 1 can be determined in real time through evaluation and analysis of the measurement data MDATA received by the data processing unit 7 of the Function Enhancement Control Cabinet Module 1 from the measurement unit 6 of the respective Function Enhancement Control Cabinet Module 1.

The Function Enhancement Control Cabinet Module 1 as illustrated in the block diagram of Fig. 1 comprises in a possible embodiment a user visualization interface 5 adapted to provide output information to a user U of the control cabinet 13 or to receive user input commands from a user U of the control cabinet 13. The user visualization interface 5 is in a preferred embodiment a touch sensitive graphical user interface (GUI). The touch sensitive user visualization interface 5 is connected as illustrated in Fig. 1 to the data processing unit 7 of the Function Enhancement Control Cabinet Module 1 and is further adapted to display an application device operation state, in particular an operation failure state, of at least one application device 15 connected to the application device interface 3 provided at the front side of the housing of the Function Enhancement Control Cabinet Module 1. The touch sensitive user visualization interface 5 is further adapted to display a momentary internal operation state of the FECCM 1. The internal FECCM operation state comprises for example internal operation voltages or operation temperatures or the state of communication connections. The touch sensitive user visualization interface 5 is further adapted to display a momentary power supply state of the power distribution system 14 of the control cabinet 13 connected to the energy interface 2 provided at the rear side of the housing of the Function Enhancement Control Cabinet Module 1. The touch sensitive user visualization interface 5 is further adapted to receive user input commands of a user U of the control cabinet 13 touching with his finger on a touch sensitive layer of the user visualization interface 5.

The user visualization interface 5 can comprise in a possible embodiment also a camera or an optical sensitive element to observe the immediate surrounding of the Function Enhancement Control Cabinet Module 1 mounted on the mounting platform of the control cabinet 13. This camera is provided in a possible embodiment on the front side of the housing of the Function Enhancement Control Cabinet Module 1. The camera can be integrated in a display unit of the user visualization interface 5. The camera of the user visualization interface 5 can be adapted to generate pictures if tis surrounding in a visible frequency range or in a not visible frequency range, in particular the infrared frequency range. The camera pictures can be processed to detect specific events within the control cabinet 13 such as light arcs or to locate heat sources within the control cabinet 13.

The user visualization interface 5 can comprise in a possible implementation an OLED display layer. The user visualization interface 5 can comprise in a possible implementation further a microphone to receive acoustic commands from a user U. The user visualization interface 5 can comprise a foldable display including an OLED display layer. By unfolding this display the available display area is increased allowing to display more and more complex information to user with a higher resolution.

In a possible embodiment the user virtualization interface 5 is removable as an entity from the housing of the Function Enhancement Control Cabinet Module 1. In a preferred implementation the user visualization interface 5 remains operative after removal from the housing of the Function Enhancement Control Cabinet Module 1 at least within a predetermined transmission range. After removal of the user visualization interface 5 a data exchange between the user visualization interface 5 and the data processing unit 7 can be performed via a wireless data link. A power supply of the removed user visualization interface 5 can be provided by a battery integrated in the user visualization interface 5.

In a still further embodiment GUIs of several neighboring application devices 15 mounted on one or more neighboring Function Enhancement Control Cabinet Modules 1 are switched automatically together by the Function Enhancement Control Cabinet Module 1 or by the control cabinet controller 17 to provide a common virtual display unit with an increased display area in response to an input user command or depending on the kind of information to be displayed. With the enlarged display area of the virtual display unit it is possible to display more complex information such as repair instructions, circuit diagrams, component lists of internal components of the respective application devices and their load devices 21A or power source devices 21B to a user. The enlarged display area of the virtual display unit allows also to display information with a higher resolution.

In a possible embodiment, the Function Enhancement Control Cabinet Module 1 as illustrated in Fig. 1 comprises a data processing unit 7 which is adapted to identify a type of the at least one application device 15 connected to the application device interface 3 at the front side of the housing of the Function Enhancement Control Cabinet Module 1. In a possible embodiment, the data processing unit 7 is further adapted to identify or determine a type of a load device 21A connected to the application device 15. The identification of the type of the application device 15 and/or of the load device 21A or power source device 21B is performed in a preferred embodiment by processing a stored current profile and voltage profile read from a data memory 11 of the data processing unit 7. The identification of the type of the application device 15 and/or its load device 21A or its power source device 21B can also be performed in a possible embodiment based on application device identification data received by the Function Enhancement Control Cabinet Module 1 from a control entity 15A of the connected application device 15. The Function Enhancement Control Cabinet Module 1 can receive in a possible implementation the application device identification data of the application device 15 via a wired application device control interface or via a wireless application device control interface. The wireless application device control interface 22 shown in Fig. 8 can comprise an RFID interface, a Near Field Communication interface, a WiFi interface or a Bluetooth interface. In this way, the microcontroller 23 of the data processing unit 7 can become aware which type of application device 15 is connected to the application device interface 3. Further, the controller 23 of the data processing unit 7 can determine what type of load device 21A or power source device 21B is connected to the application device 15 connected to the application device interface 3. For instance, the controller 23 of the data processing unit 7 can determine whether a resistive load device 21A, an inductive load device 21A or a capacitive load device 21A is connected to the application device interface 3 through the application device 15 or adapter. Further, it can for instance be determined by the microcontroller 23 whether the power source device 21B is an AC power source or a DC power source and how much power is generated by the power source device 21B.

In a possible embodiment of the Function Enhancement Control Cabinet Module 1, device operation boundary data and/or device characteristics stored in a configuration memory 15B of the application device 15 connected to the application device interface 3 can be transmitted via a communication channel of the wired or wireless application device control interface 22 to the data processing unit 7 of the Function Enhancement Control Cabinet Module 1 as shown in Fig. 8. These device operation boundary data or limit data can comprise in a possible embodiment a maximum and/or a minimum admissible supply current of the application device 15, a maximum and/or minimum admissible supply voltage of the application device 15 or its load device 21A, a maximum and/or minimum admissible operation temperature of the application device 15, an allowable I²t value and/or a maximum switching frequency of the connected application device 15 or load device 21A.

In a possible embodiment of the Function Enhancement Control Cabinet Module 1, the data processing unit 7 of the Function Enhancement Control Cabinet Module 1 is adapted to perform automatically a pre-configuration of possible functions of the connected application device 15 on the basis of the application device identification data and/or on the basis of the device operation boundary data and/or on the basis of the device characteristics received by the data processing unit 7 via the wired or wireless application device control interface 22 illustrated in Fig. 8.

In a further possible embodiment of the Function Enhancement Control Cabinet Module 1 according to the first aspect of the present invention required functions of the Function Enhancement Control Cabinet Module 1 can be pre-configured or re-configured automatically depending on a detected type of the application device 15 or its load devices 21A or its power source devices 21 B or depending on an input type of the application device 15 input by a user by means of the user interface. These configurable functions may comprise for instance matching algorithms such as a current monitoring algorithm for current monitoring or for coupling of auxiliary outputs to current threshold values voltage, threshold values or to temperature threshold values. The algorithm or function does match the type of the application device 15 and/or its load or source devices. The functional algorithm can be loaded through the control interface 4 from a database or function library or can be loaded from a local memory into the microcontroller 23 of the data processing unit 7.

The power distribution system 14 of the control cabinet 13 comprises in a possible embodiment an internal AC power distribution system 14 having at least one AC power supply phase L applied to a corresponding electrical contact of the energy interface 2 provided at the rear side of the housing of the Function Enhancement Control Cabinet Module 1 connected to the AC power distribution system 14 of the control cabinet 13. In an alternative embodiment, the power distribution system 14 of the control cabinet 13 can also comprise a DC power distribution system.

In a possible embodiment of the Function Enhancement Control Cabinet Module 1 as illustrated in Fig. 1, the data processing unit 7 included in the housing of the Function Enhancement Control Cabinet Module 1 and/or an external control cabinet controller 17 of the control cabinet 13 connected through the control interface 4 of the Function Enhancement Control Cabinet Module 1 can be adapted to process the measurement data MDATA stored in the data memory 11 of the data processing unit 7, application device identification data stored in the data memory 11 of the data processing unit 7 and/or the available device operation boundary data of the application device 15 connected to the application device interface 3 of the Function Enhancement Control Cabinet Module 1 and loaded in the data memory 11 of the data processing unit 7 in real time.

In a possible implementation of the Function Enhancement Control Cabinet Module 1 according to the first aspect of the present invention, the stored device operation boundary data loaded into the data memory 11 comprises a maximum and minimum admissible supply current, a maximum and minimum admissible supply voltage, a maximum and minimum admissible operation temperature, an I²t value and/or a maximum switching frequency of the connected application device 15.

By processing the available measurement data MDATA, the application device identification data and the device operation boundary data, a processor or controller 23 of the data processing unit 7 can optimize an electrical power supply to the application device 15 connected to the application device interface 3. Further, by processing the available data, the controller 23 of the data processing unit 7 can provide in a possible implementation an effective overcurrent protection or overload protection of the application device 15 connected to the application device interface 3. The microcontroller 23 of the data processing unit 7 can further provide in a possible implementation also an overcurrent protection and/or an overload protection of any load device 21A connected to the application device 15 on the basis of the available measurement data MDATA, the available application device identification data and/or on the basis of the available device operation boundary data stored in the data memory 11 of the data processing unit 7. In a possible embodiment, the microcontroller 23 of the data processing unit 7 can further be adapted to control in real time an operation state of the connected application device 15 and/or to control an operation state of a load device 21A or power source device 21B connected to the application device 15 on the basis of the available measurement data, the available device operation boundary data and/or the application device identification data stored in the data memory 11 of the data processing unit 7.

The measurement data, the application device identification data and the device operation boundary data can be recorded and stored in a possible embodiment continuously or event-driven in a local non-volatile data memory 11 of the data processing unit 7 of the Function Enhancement Control Cabinet Module 1. The processor 12 of the data processing unit 7 is adapted to evaluate the stored measurement data, the stored application device identification data and the stored device operation state of the application device 15 connected to the application device interface 3 provided at the front side of the housing of the Function Enhancement Control Cabinet Module 1 to detect or predict a failure of the connected application device 15. In a possible embodiment, the detected or predicted failure is notified to the internal microcontroller 23 or FPGA of the data processing unit 7 or to an external control cabinet controller 17 of the control cabinet 13 connected to the control interface 4 of the Function Enhancement Control Cabinet Module 1 to trigger corresponding countermeasures to overcome the failure of the application device 15 or its load device 21.

In a possible implementation, the external control cabinet controller 17 connected to the control interface 4 of the Function Enhancement Control Cabinet Module 1 is adapted to trigger automatically a repair or a maintenance action or a troubleshooting action to address the notified failure of the application device 15 connected to the application device interface 3.

The acquisition of the measurement data MDATA and the acquisition of the application device identification data and/or the acquisition of the device operation boundary data can be triggered and controlled in a possible embodiment by a control entity 15A of the application device 15 connected to the application device interface 3 as shown in Fig. 7. In an alternative embodiment, the acquisition of the measurement data, the acquisition of the application device identification data and/or the acquisition of the device operation boundary data can be triggered and controlled by a microcontroller 23 or FPGA integrated in the data processing unit 7 provided in the internal circuitry of the Function Enhancement Control Cabinet Module 1 shown in Fig. 8. In a still further alternative embodiment, the acquisition of the measurement data, the acquisition of the application device identification data and/or the acquisition of the device operation boundary data can be triggered and controlled by the external control cabinet controller 17 of the control cabinet 13 connected to the control interface 4 of the Function Enhancement Control Cabinet Module 1 shown in Fig. 7. The control of the acquisition of measurement data MDATA can involve the adjustment of the sampling rate SR of the ADCs 10 as well as control of a preprocessing of the sampled measurement raw data by preprocessing entities comprising digital filters of the data processing unit 7.

The acquired measurement data MDATA stored in the local non-volatile data memory 11 of the data processing unit 7 is evaluated in a possible embodiment by a processor 12 of the data processing unit 7 of the Function Enhancement Control Cabinet Module 1 to determine specific data patterns representing associated application device operation states of the at least one application device 15 connected to the application device interface 3 and/or representing associated power supply states of the power distribution system 14 of the control cabinet 13 connected to the energy interface 2 of the Function Enhancement Control Cabinet Module 1.

The data processing unit 7 shown in Fig. 1 can include in a possible implementation a trained artificial neural network ANN adapted to recognize automatically application device operation states of the application device 15 connected to the application device interface 3 provided at the front side of the housing of the Function Enhancement Control Cabinet Module 1. The trained artificial neural network ANN provided in the data processing unit 7 of the Function Enhancement Control Cabinet Module 1 can be further adapted to recognize power supply operation states of the power distribution system 14 of the control cabinet 13 connected to the energy interface 2 provided at the rear side of the housing of the Function Enhancement Control Cabinet Module 1. The automatic recognition of the application device operation states and of the power supply operation states are performed by one or more integrated artificial neural network ANN implemented in associated processors 12 of the data processing unit 7 on the basis of measurement data MDATA received by the respective artificial neural network ANN of the data processing unit 7 from the galvanically isolated measurement unit 6 of the Function Enhancement Control Cabinet Module 1 or read from the local non-volatile data memory 11 of the data processing unit 7. The measurement data MDATA is applied to an input layer of the trained artificial neural network ANN of the data processing unit 7 to provide automatically a classification result output by an output layer of the trained artificial neural network ANN to a microcontroller 23 or to an FPGA of the data processing unit 7. Depending on the classification results, the microcontroller 23 or FPGA of the data processing unit 7 can initiate operations depending on the recognized application device operation state of the application device 15 and/or depending on the recognized power supply operation state of the power distribution system 14. The artificial neural network ANN can also be integrated in the control cabinet controller 17 or in the central control unit 20 shown in Fig. 9.

The data processing unit 7 of the Function Enhancement Control Cabinet Module 1 as shown in Fig. 1 is adapted in a possible embodiment to communicate with the external control cabinet controller 17 connected to the control interface 4 of the Function Enhancement Control Cabinet Module 1 by means of a predefined data transfer protocol including a field bus data transfer protocol or an Ethernet-based data transfer protocol. Field bus protocols can comprise an I/O link or a Modbus TCP protocol. The field bus can be connected directly to a PLC or through a repeater or router. The measurement data MDATA can be encapsulated as payload in data packets supplied by the data processing unit 7 to the cabinet controller 17. The header of each data packet comprises a unique identifier (FMCCI-ID) of the Function Enhancement Control Cabinet Module 1 as a data source address. The FMCCI-ID is in a preferred embodiment unique within the automation system and can be assigned during a setup of the automation system.

The application device 15 connected to the application device interface 3 provided at the front side of the housing of the Function Enhancement Control Cabinet Module 1 as illustrated schematically in Fig. 1 can comprise in a possible embodiment a switchable or non-switchable load connector for a load device 21A. Further, the application device 15 connected to the application device interface 3 may also comprise in a possible embodiment a meltable or an electronic-controlled fuse element.

In a possible embodiment, the energy interface 2 provided at the rear side of the housing of the Function Enhancement Control Cabinet Module 1 can comprise several electrical contacts for AC power supply phases L of a multiphase power distribution system 14. Also, the application device interface 3 provided at the front side of the housing of the Function Enhancement Control Cabinet Module 1 can comprise several electrical contacts for different AC power supply phases L of a multiphase application device 15 connectable to the application device interface 3 provided at the front side of the housing of the Function Enhancement Control Cabinet Module 1.

The at least one data processor 12 of the data processing unit 7 as shown in Figs. 4, 8 is adapted to calculate in a possible embodiment a phase relationship between different electrical AC power supply phases L supplied via the bidirectional internal power supply paths PSPs of the Function Enhancement Control Cabinet Module 1 to the load devices 21A of the application device 15. The processor 12 can be further adapted to determine automatically a frequency f of the electrical AC power supply phases L of an AC power distribution system 14 based on the measurement data MDATA received by the data processing unit 7 from the measurement unit 6 of the Function Enhancement Control Cabinet Module 1. For instance, the processor 12 can determine whether the frequency f of the electrical AC power supply phases L comprises 50 Hz or 60 Hz. It is further determined in a possible embodiment by the data processing unit 7 whether the observed frequency f of the AC power distribution system 14 is in an admissible frequency range for operation of connected load devices 21A .Further in a possible embodiment the data processing unit 7 is adapted to perform an automatic compatibility check whether the connected load devices 21A connected via the adapter device 15 and the respective sandwiched Function Enhancement Control Cabinet Module 1 to the power distribution system 14 are compatible with the observed operation frequency f of the local power distribution system 14 of the control cabinet 13. In case that the connected load device 21A is not compatible this can be displayed to a user U through the user visualization interface 5 and the load device 21A can be automatically disconnected by a switch under control of the microcontroller 23 of the data processing unit 7. If a local power generation device 21B is available a frequency deviation of the observed frequency f from a set frequency can be compensated locally.

In a further possible embodiment, the processor 12 of the data processing unit 7 is further adapted to calculate automatically a real power, a reactive power and/or an apparent power for each phase L of the multiphase electrical AC power supply system. Further, the processor 12 can calculate in a possible implementation also a summed real, reactive and apparent power value for the multiphase power distribution system 14. The processor 12 does accumulate energy values related to single phases or related to multiple phases of a multiphase power distribution system 14 of the control cabinet 13. The calculation of the phase relationship and/or of the power and energy values are performed by execution of a programmable calculation algorithm stored in a program memory accessible by the processor 12 of the data processing unit 7. The program can be loaded in a possible embodiment through the control interface 4 of the Function Enhancement Control Cabinet Module 1 from a server or central control unit 20 of the automation system shown in Fig. 9.

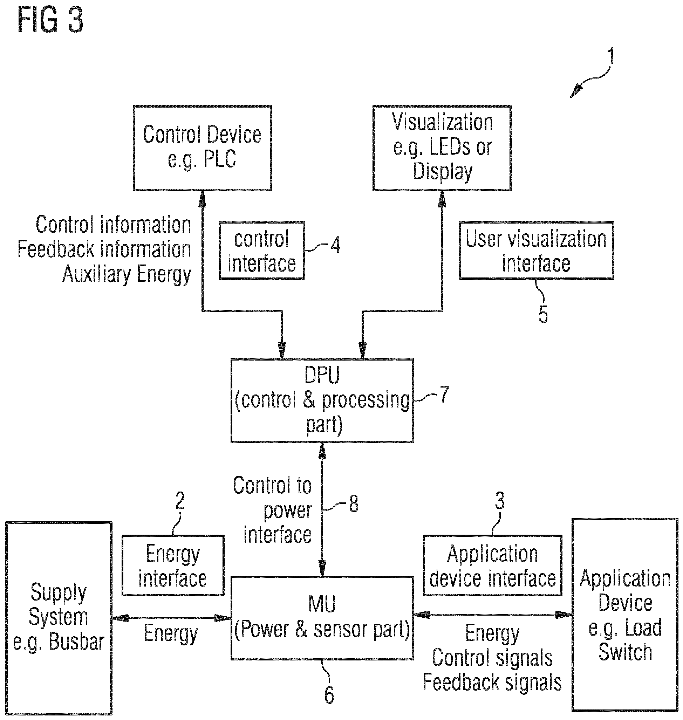

In a possible embodiment of the Function Enhancement Control Cabinet Module 1 as illustrated in the block diagram of Fig. 1, the measurement unit 6 of the Function Enhancement Control Cabinet Module 1 can be integrated in a measurement submodule connected via an internal data and control interface 8 to the data processing unit 7 of the Function Enhancement Control Cabinet Module 1 integrated in a separate data processing submodule as illustrated in Fig. 3. Both submodules form the internal circuitry of the Function Enhancement Control Cabinet Module 1. For this purpose, the measurement submodule 6 is connectable to the data processing submodule 7 via an internal data and control interface 8 to provide the Function Enhancement Control Cabinet Module 1. This is also illustrated in Fig. 3. As can be seen in Fig. 3, the measurement submodule 6 is connected to the data processing submodule 7 via an internal data and control interface 8. The measurement submodule 6 comprises the energy interface 2 and on the opposite side the application device interface 3. The other submodule, i.e. the data processing submodule 7 comprises the other two interfaces, i.e. the control interface 4 and the user visualization interface 5. The internal data and control interface 8 is adapted to provide galvanic isolation between the measurement submodule 6 and the data processing submodule 7. The measurement submodule 6 includes the energy input interface 7 and the application device interface 3 as well as the measurement unit 6 where voltage, current and temperature sensing is performed. The measurement submodule 6 is formed such that it provides for minimum dissipation and requires a minimum space within the control cabinet 13.

The data processing submodule 7 comprises the control interface 4 and the user visualization interface 5. The data processing unit 7 can be optimized to meet user demands like comprehensive visualization and flexible connectivity. In the embodiment illustrated in Fig. 3, the power carrying interfaces 2, 3 are separated from the control interface 4 and the user visualization interface 5 to optimize both components or parts independently depending on the respective use case. Further, different kinds of measurement submodules 6 and data processing modules 7 can be combined with each other through the galvanically isolated control and power interface 8 to meet requirements of different use cases. For instance, measurement submodules 6 with different kinds of measurement sensors or sensor elements can be combined with different kinds of data processing submodules 7 providing different levels of calculation and data analyzing capabilities or memory capacities. In a possible embodiment, the data processing submodule 7 is plugged into the measurement submodule 6 to form a Function Enhancement Control Cabinet Module 1. In this embodiment, the measurement submodule 6 is integrated in its own submodule housing. In the same manner, the data processing submodule 7 also comprises its own housing. By plugging the measurement submodule 6 into the data processing submodule 7, the complete Function Enhancement Control Cabinet Module 1 is formed and can be mounted to the mounting platform of the control cabinet 13.

Fig. 4 shows a further block diagram for illustrating a possible exemplary embodiment of the Function Enhancement Control Cabinet Module 1 according to the first aspect of the present invention. As can be seen in Fig. 4, the measurement unit 6 provided between the energy interface 2 and the application device interface 3 comprises a sensor 9 connected to an associated analog to digital converter 10. The analog to digital converter 10 provides measurement data MDATA to a data memory 11 of the data processing unit 7. The data processing unit 7 further comprises in the illustrated embodiment of Fig. 4 a processor 12 adapted to process the data stored in the data memory 11 of the data processing unit 7. The data memory 11 can be used to store measurement data MDATA received from the analog to digital converter 10. The data memory 11 can also store additional data including device operation boundary data or device characteristics received from a configuration memory 15B of the application device 15 connected to the application device interface 3. The data memory 11 can also be used to store application device identification data. The processor 12 of the data processing unit 7 can process the measurement data MDATA stored in the data memory 11 to calculate a phase relationship between different electrical AC power supply phases L (L1, L2, L3) supplied via an internal power supply path PSP of the Function Enhancement Control Cabinet Module 1 and/or to determine a frequency of the electrical AC power supply phases L. Further, the processor 12 can calculate a real power, a reactive power and/or an apparent power for each phase L of the multiphase AC power supply system. The processor 12 can also calculate a summed up real, reactive and apparent power values of a multiphase AC power distribution system and/or accumulate energy values related to single phases or related to multiple phases of the multiphase power distribution system. The data processing unit 7 can also be adapted to control functions of the application device 15 connected to the application device interface 3 provided at the front side of the housing of the Function Enhancement Control Cabinet Module 1 via a separate application device control interface 22 also provided at the front side of the housing of the Function Enhancement Control Cabinet Module 1 as also illustrated in Fig. 8.

In a possible embodiment, the measurement data MDATA stored in the memory 11 of the data processing unit 7 can be forwarded to the external control cabinet controller 17 connected to the control interface 4 of the Function Enhancement Control Cabinet Module 1 along with a unique identifier (FECCM-ID) of the Function Enhancement Control Cabinet Module 1 for further processing. The transmission of the measurement data MDATA can be performed according to the applied data transfer protocol. Also, failure messages indicating a failure of the Function Enhancement Control Cabinet Module 1 and/or a failure of an application device 15 connected to the application device interface 3 or a connected load device 21 can be forwarded to the external control cabinet controller 17 connected to the control interface 4 along with the unique identifier of the Function Enhancement Control Cabinet Module 1 for further data evaluation. Also, information indicating a mounting position of the affected Function Enhancement Control Cabinet Module 1 can be forwarded through the control interface 4 to the control cabinet controller 17 and be taken into account for performing the necessary counter actions. The control cabinet controller 17 of the control cabinet 13 is adapted to compare the measurement data MDATA received by the control cabinet controller 17 via the different control interfaces 4 from the different Function Enhancement Control Cabinet Modules 1 mounted in the control cabinet 13 to identify a deviating operation behavior of an affected Function Enhancement Control Cabinet Module 1. In case that the Function Enhancement Control Cabinet Module 1 shows a significantly deviating operation behavior to other Function Enhancement Control Cabinet Modules 1, an data analyzing routine can be triggered to determine what kind of failures have occurred in the affected Function Enhancement Control Cabinet Module 1.

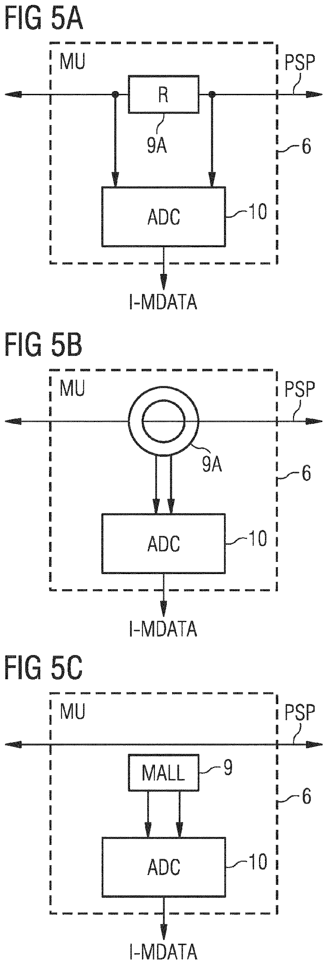

The measurement unit 6 of the Function Enhancement Control Cabinet Module 1 can comprise different kinds of sensor elements to generate sensor signals which are converted into measurement data MDATA. In a possible embodiment, the measurement unit 6 comprises at least one current sensor 9A adapted to measure an electrical current I flowing through the power supply path PSP of the Function Enhancement Control Cabinet Module 1. The current sensor 9A of the measurement unit 6 is adapted to measure the electrical current I flowing through the internal power supply path PSP and can comprise at least one shunt resistor as illustrated in Fig. 5A, a current transformer or a Rogowski coil as illustrated in Fig. 5B or a Hall sensor as illustrated in Fig. 5C. The sensor signal generated by the current sensor 9A can be sampled with a sampling rate SR and converted by an analog to digital converter 10A of the measurement unit 6 to generate current measurement data I-MDATA, supplied by the measurement unit 6 to the data processing unit 7 of the Function Enhancement Control Cabinet Module 1 and stored in a local non-volatile data memory 11 of the data processing unit 7 as a current profile I-PROFILE. The current profile I-PROFILE comprises a number of current samples stored in the data memory 11 of the data processing unit 7. Current sensing as illustrated in Fig. 5A is limited in terms of power dissipation but allows also a DC current to be sensed. Further, the sensing principle illustrated in Fig. 5A is not sensitive to magnetic fields nearby the current sensor element. Furthermore, the integration of a shunt resistor R as illustrated in Fig. 5A to the electromechanical internal structure of the Function Enhancement Control Cabinet Module 1 allows for a space saving design. For instance, a stack of four shunt sensors R of the measurement unit 6 integrated in a cross link interface of an electromechanical building block is illustrated in Fig. 14. In the implementation shown in Fig. 14, the lower side of the electromechanical building block forms the energy interface 2 and the upper side forms the application device interface 3. In the illustrated implementation of Fig. 14, the energy interface 2 provided at the rear side of the housing of the Function Enhancement Control Cabinet Busbar Module 1 comprises electrical contacts 29 protruding from the rear side of the housing of the Function Enhancement Control Cabinet Busbar Module 1. These protruding electrical contacts 29 can be plugged in a possible implementation into corresponding slots 36 of busbars 30 of the power distribution system 14 of the control cabinet 13 as shown in Fig. 13. The application device interface 3 provided at the front side of the housing of the Function Enhancement Control Cabinet Module 1 comprises in the illustrated embodiment of Fig. 14 at least one busbar portion of an internal busbar 31 included in the housing of the Function Enhancement Control Cabinet Busbar Module 1 and forming part of the internal bidirectional power supply path PSP. As can be seen in Fig. 14, the busbar portion of the internal busbar 31 also comprises slots 32 into which in turn protruding electrical contacts 33 of an application device 15 can be plugged for instance through associated contact openings 34 provided at the front side of the housing of the Function Enhancement Control Cabinet Module 1 as also shown in Fig. 13.

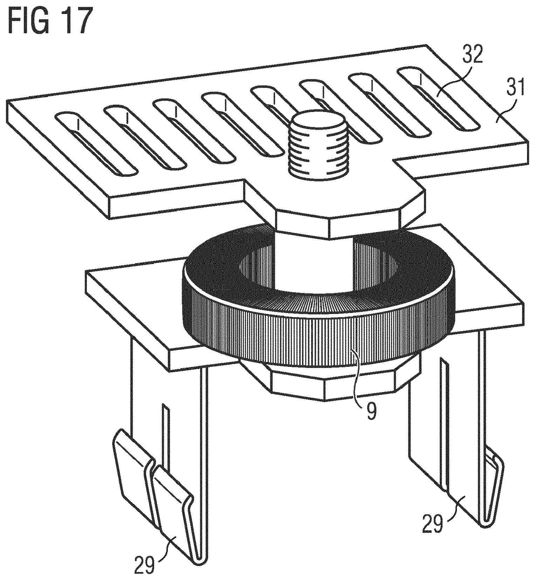

In an alternative embodiment, to overcome drawbacks caused by power dissipated related to a shunt resistor R, a Rogowski coil 9A can be used for generation of a current measurement signal as illustrated in Fig. 5B and in Fig. 17. The usage of a Rogowski coil 9A is useful for any use case where electrical AC currents may occur. Rogowski sensors 9A can also be manufactured with a small form factor to achieve a compact setup of the Function Enhancement Control Cabinet Busbar Module 1.

Fig. 17 illustrates the measurement unit 6 using a small form factor Rogowski coil 9A for performing measurements at the internal power supply path PSP as also illustrated schematically in Fig. 5B. Besides a Rogowski coil, a classical current transformer can also be used for performing electrical current sensing. This kind of sensor is widely used and can be manufactured with a high accuracy and is sufficient for energy metering.

To extend the capability of DC measurements without drawbacks of too much power dissipation, a Hall sensor 9A can be used as a sensing element of the measurement unit 6 as illustrated in Fig. 5C. The Hall sensor 9A can be placed externally nearby the conductor of the power supply path PSP which carries the electrical current I of interest. It is also possible to use multiple Hall sensors surrounding the conductor of the power supply path PSP. In this way, sufficient common field immunity can be ensured. A calibration procedure with a setup close to the application is required for use of such an external sensor setup as shown in Fig. 5C.

The direction of the magnetic field lines of the magnetic field generated by the flowing electrical current I measured by the current sensor 9A can be determined in a possible embodiment to detect a flowing direction of the electrical current I based on the measurement data MDATA provided by the current sensor 9A of the measurement unit 6 to the data proceeding unit 7.In this way it is can be determined whether the electric power supply current I is flowing in a forward power supply direction as shown in Fig.20A or in a reverse power supply direction as shown in Fig.20B. This works for a DC power supply current. For an AC current the phase relationship between voltage and current indicates whether the device is a power source or power sink (a phase angle of 0 to 90 degrees indicates a power source and a phase angle indicates a power sink).

The use of a Rogowski coil, a current transformer or an Hall sensor as the sensor element 9A provides intrinsic galvanic isolation from the current carrying power supply path PSP.

In a possible implementation, an integrated Hall sensor 9 can be used where the electrical load current I is passed through the sensor housing. With this setup, a common field suppression and calibration can be performed directly by the device manufacturer. This can lead to a compact subsystem in industry standard integrated circuit packages. This eases the efforts for the end user.

In contrast, the shunt resistor R as illustrated in Fig. 5A is directly coupled to the conductor of the power supply path PSP provided between the energy interface 2 and the application device interface 3. The signal, i.e. a voltage drop along the resistor 9A can be applied to an amplifier and to the analog to digital converter 10A on a high voltage potential wherein the digital information generated in response to the sensor signal is supplied to the data processing unit 7 via standard digital isolator building block. In this embodiment, an isolated power supply is required on the high voltage side and may increase complexity of the Function Enhancement Control Cabinet Busbar Module 1.

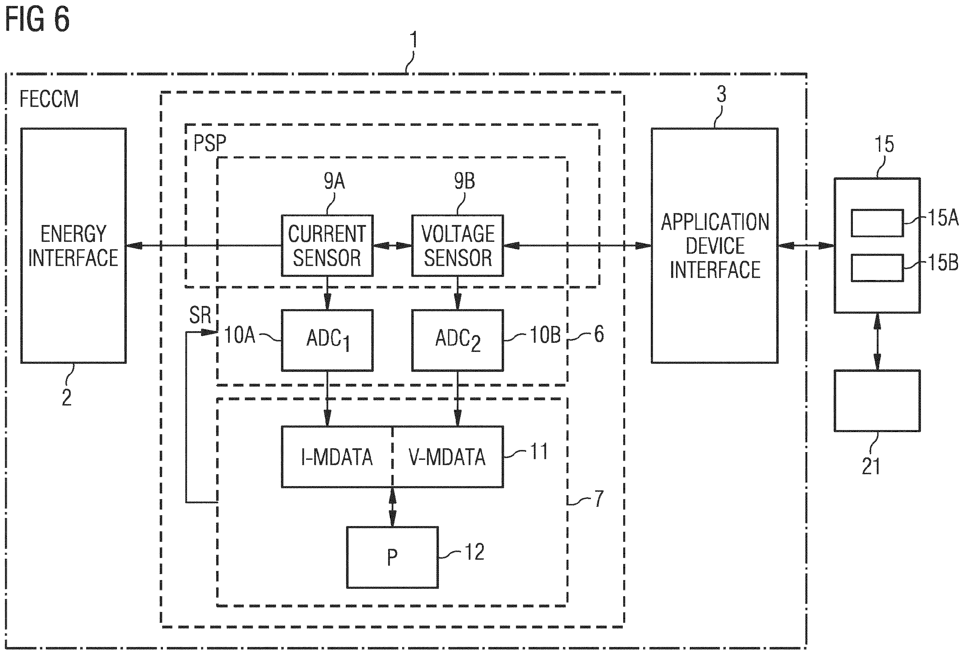

Fig. 6 shows a further block diagram for illustrating a possible embodiment of a Function Enhancement Control Cabinet Busbar Module 1 according to the first aspect of the present invention. In the illustrated embodiment, the measurement unit 6 not only comprises a current sensor 9A, but also a voltage sensor 9B. The current sensor 9A is adapted to measure the electrical current I flowing through the power supply path PSP. The voltage sensor 9B is adapted to measure an electrical voltage V at the power supply path PSP. The current sensor 9A of the measurement unit 6 is adapted to measure the electrical current I flowing through the internal power supply path PSP and is adapted to provide a current sensor signal sampled and converted by a first analog to digital converter 10A of the measurement unit 6 to generate current measurement data I-MDATA supplied by the measurement unit 6 to the data processing unit 7 and stored in a local non-volatile data memory 11 of the data processing unit 7 as a current profile I-PROFILE as shown in Fig. 6.

The voltage sensor 9B is adapted to measure the electrical voltage V at the internal power supply path PSP and is adapted to provide a voltage sensor signal sampled and converted by a second analog to digital converter 10B of the measurement unit 6 to generate voltage measurement data V-MDATA supplied by the measurement unit 6 to the data processing unit 7 of the Function Enhancement Control Cabinet Module 1 and stored in the local non-volatile data memory 11 of the data processing unit 7 as a voltage profile V-PROFILE.

In a further embodiment, a temperature sensor 28A of the measurement unit 6 (shown in Fig. 8) can be adapted to measure also a temperature T at the internal power supply path PSP provided within the housing of the Function Enhancement Control Cabinet Module 1 and to supply a corresponding temperature measurement signal to a third analog to digital converter 28B of the measurement unit 6 adapted to generate a temperature measurement data T-MDATA supplied to the data processing unit 7 of the Function Enhancement Control Cabinet Module 1 and stored in the local non-volatile data memory 11 of the data processing unit 7 as a temperature profile T-PROFILE.

In a possible embodiment, the microcontroller 23 of the data processing unit 7 can be adapted to control the sampling rate SR of the employed analog to digital converters 10A, 10B as shown in Fig. 6. Accordingly, in a possible embodiment, in a specific operation mode, the sampling rate SR of the analog to digital converters 10A can be increased to take into account specific observed operation states, current profiles and/or voltage profiles with a higher time resolution. In this way, a more accurate data analysis of voltage profiles V-PROFILEs and/or current profiles I-PROFILEs within specific time windows of interest can be performed by the processor 12 of the data processing unit 7. On the other hand, the sampling rate SR can be decreased to save storage space in the data memory 11.

The analog to digital converters 10 of the measurement unit 6 can use a common time grid applicable to all Function Enhancement Control Cabinet Modules 1 installed in the control cabinet 13. In this way, it is possible to compare measurement data MDATA stored in data memories 11 of different Function Enhancement Control Cabinet Modules 1 mounted in the control cabinet 13 an identified by their unique FMCCI-IDs. In a possible embodiment, the current samples i generated by the analog to digital converter 10A and the voltage samples v generated by the analog to digital converter 10B are tagged with a time stamp so that a set of current and/or voltage samples generated by different measurement units 6 located at different positions within the control cabinet 13 can be compared to each other during operation of the automation system in real time to detect causal relationships between different entities mounted within the control cabinet 13 based on the stored current profiles ,I-PROFILEs, and/or voltage profiles , V-PROFILEs. In a possible embodiment, the control cabinet controller 17 can comprise a clock signal generator generating a clock signal CLK distributed through the control interfaces 4 of the different Function Enhancement Control Cabinet Modules 1 to the measurement units 6 and the data processing units 7 of the Function Enhancement Control Cabinet Modules 1 to provide a common time grid.

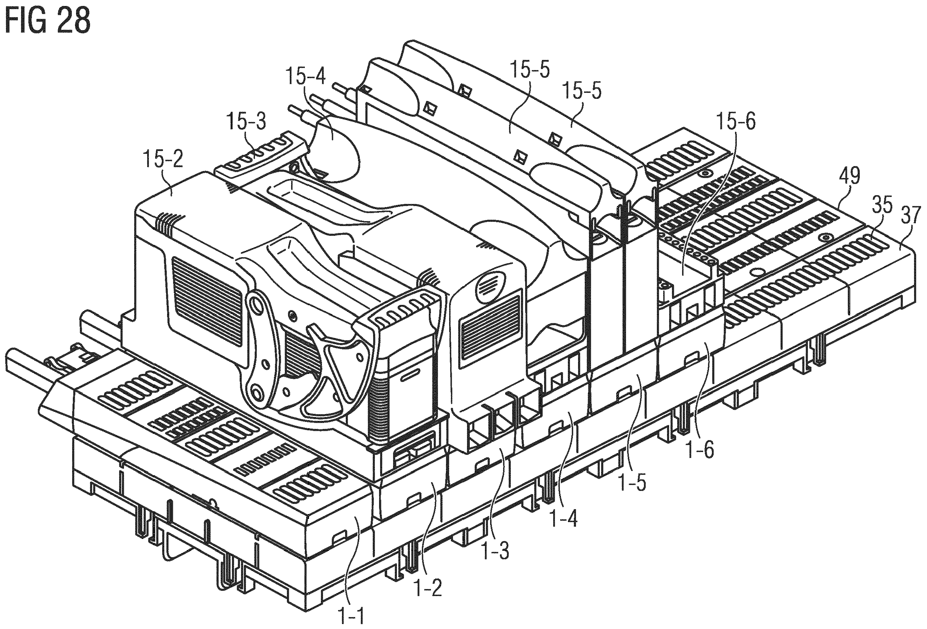

Fig. 7 shows a further block diagram for illustrating a possible exemplary embodiment of a control cabinet 13 according to a further aspect of the present invention. As can be seen in the block diagram, the Function Enhancement Control Cabinet Module 1 according to the first aspect of the present invention is connected by means of its energy interface 2 to the power distribution system 14 of the control cabinet 13. On the front side of the housing of Function Enhancement Control Cabinet Module 1, at least one application device 15 can be connected as shown in Fig. 7. The control interface 4 of the Function Enhancement Control Cabinet Module 1 is connected through a control cabinet bus system 16 to a control cabinet controller 17 of the control cabinet 13. The control cabinet bus system 16 comprises in a possible embodiment a wireless or a wired control cabinet bus system 16. The control cabinet 13 as shown in Fig. 7 can comprise a plurality of Function Enhancement Control Cabinet Modules 1 mounted to a mounting platform of the control cabinet 13. The control cabinet 13 comprises an internal power distribution system 14. The power distribution system 14 can comprise a multiphase AC power distribution system or in an alternative embodiment a DC power supply system. In a possible implementation, the power distribution system 14 of the control cabinet 13 can comprise a power distribution busbar system having busbars 30 used for power distribution within the control cabinet 13. In a possible embodiment, the busbars 30 of the power distribution busbar system 14 of the control cabinet 13 can be touch-protected to provide protection for a user U of the control cabinet 13. In a specific embodiment, the busbars 30 of the power distribution busbar system 14 can be encapsulated by a touch protection busbar board 49 as shown in Fig. 28. The busbar board 49 can also be referred to a cross board or crosslink board which is normally mounted horizontally within the control cabinet. The busbar board 49 comprises in a preferred embodiment contact openings or slots 35 within a touch protection front surface 37 of the busbar board 49 to receive protruding electrical contacts 29 of the energy interface 2 of the Function Enhancement Control Cabinet Module 1 being pluggable through contact openings 35 provided at the front side of the touch protection busbar board 36 into corresponding slots 36 of the encapsulated busbars 30 of the power distribution busbar system 14 lying directly beneath the contact openings 35 of the busbar board 49 as also shown in the cross section view of Fig. 13. The busbars 30 of the power distribution busbar system 14 of the control cabinet 13 are mounted in a preferred embodiment in a horizontal direction within the control cabinet 13.

Similarly, a multiphase application device 15 may also comprise protruding electrical contacts 33 being pluggable through corresponding contact openings 34 provided at the front side of the housing of the multiphase Function Enhancement Control Cabinet Module 1 into slots 32 of internal busbars 31 included in the housing of the multiphase Function Enhancement Control Cabinet Module 1. In this way, it is possible to establish an electrical contact via the bidirectional internal power supply paths PSPs of such a multiphase Function Enhancement Control Cabinet Module 1 with the electrical contacts 29 of the energy interface 2 provided at the rear side of the housing of the multiphase Function Enhancement Control Cabinet Module 1 and to provide a connection with the power distribution busbar system 14 of the control cabinet 13.

Fig. 9 illustrates the architecture of the different entities in a control cabinet 13 forming part of a complex automation system. In the illustrated embodiment, the automation system comprises several control cabinets 13-i, 13-j connected to a common data network 19 via data interfaces 18-i, 18-j of the respective control cabinets 13-i, 13-j. The data network 19 can be a local data network or Intranet of the automation system. The data network 19 can be connected to a local or remote server of a central control unit 20 as shown in Fig. 9. Each control cabinet 13-i, 13-j can comprise a different number of Function Enhancement Control Cabinet Modules 1 as shown in Fig. 9. In the illustrated embodiment, the control cabinet 13-i comprises a number N1 of Function Enhancement Control Cabinet Modules 1 and the other control cabinet 13-j comprises a number N2 of Function Enhancement Control Cabinet Modules 1. The server 20 can receive data from any Function Enhancement Control Cabinet Module 1 mounted in any control cabinet 13 of the automation system. In this way, it is possible to compare different data received from the different Function Enhancement Control Cabinet Modules 1 and to perform an automatic analysis across different entities of the automation system. In this way, a sophisticated algorithm performed by the server 20 is capable of comparing the different available data and to draw automatically conclusions as to the root cause of an observed failure event within the automation system. This is facilitated since the different measurement data and profiles comprise data samples with an associated time stamp and sampled by using a common clock signal CLK to provide a common time grid for data evaluation. A server of a central control unit 20 can communicate with the controllers 17-i, 17-j of the different control cabinets 13-i, 13-j depending on the observed observation scenario and can trigger a transfer of necessary data to the server of the automation system in response to a request sent by the server 20 to the respective controller 17. The controllers 17-i, 17-j of the respective control cabinets 13-i, 13-j can communicate with a controller 23 integrated in the different data processing units 7 of the Function Enhancement Control Cabinet Modules 1 mounted in the respective control cabinet 13. The controller 17 of a control cabinet 13 can communicate with the controller 23 integrated in a data processing unit 7 of a Function Enhancement Control Cabinet Module 1 to trigger the generation, preprocessing and/or transmission of measurement data MDATA or other data of interest stored in a local data memory of the controller 17 and to forward data through the data network 19 to the server 20 for further processing. In this way, the server of the central control unit 20 can send a request for receiving sampled data in specific time windows of interest from different entities within the same or different control cabinets 13 of the automation system. For instance, if an overcurrent event is observed by a specific Function Enhancement Control Cabinet Module 1 within the automation system, a processor of the server of the central control unit 20 can take a close look to corresponding measurement data MDATA and profiles of other Function Enhancement Control Cabinet Modules 1 within the same or another control cabinet 13 to find a root cause for the observed failure. The data can also be evaluated to predict an imminent failure of a component or entity within the automation system. It is also possible that the central control unit 20 or server of the automation system can increase the sampling rate SR of the analog to digital converters 10 to generate sensor profiles with a higher time resolution in a critical operation state where an imminent failure is likely. In this way, a more reliable evaluation of a specific event based on the stored sensor data can be performed because a higher number of available data samples is provided within the observed time window. In a possible embodiment, the sampling rates SR of the ADCs 10A, 10B, 28B are adjusted event-driven.

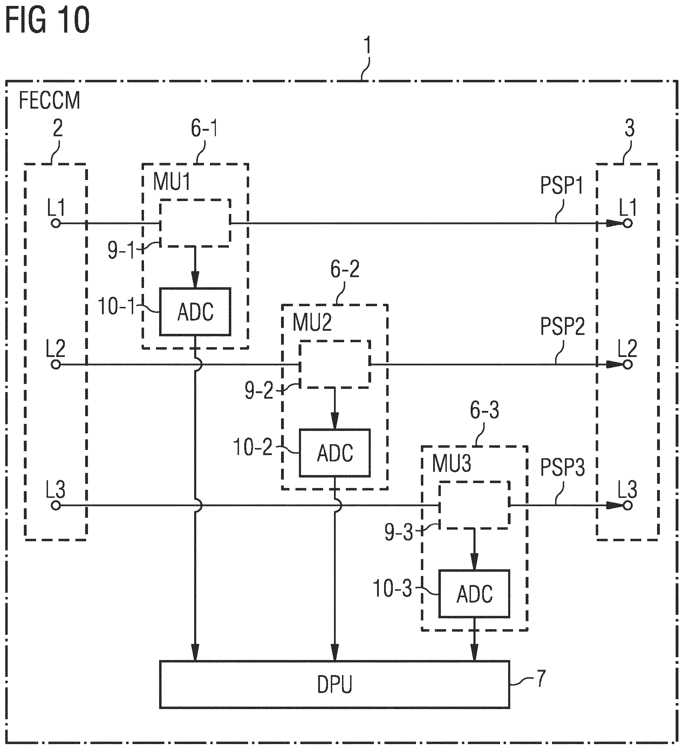

Fig. 10 shows a block diagram for illustrating a possible exemplary embodiment of a Function Enhancement Control Cabinet Module 1 according to the present invention. In the illustrated embodiment, the Function Enhancement Control Cabinet Module 1 comprises a multiphase Function Enhancement Control Cabinet Module 1 used for three different phases L1, L2, L3 of a three-phase AC power distribution system 14 of the control cabinet 13. Also, the application device interface 3 comprises three electrical contacts for three different electrical phases L1, L2, L3. Accordingly, the Function Enhancement Control Cabinet Module 1 shown in the schematic diagram of Fig. 10 comprises three parallel power supply paths PSP1, PSP2, PSP3. Each power supply path PSP is in a preferred embodiment a bidirectional power supply path. For each power supply path PSP1, PSP2, PSP3 of the Function Enhancement Control Cabinet Module 1, an associated measurement unit 6-1, 6-2, 6-3 can be provided having its integrated analog to digital converter 10 providing measurement data MDATA to the data processing unit 7 of the Function Enhancement Control Cabinet Module 1. Each measurement unit 6-i may comprise one or more sensor elements 9-1, 9-2, 9-3 as shown in Fig. 10. The received measurement data can be stored in a possible embodiment in a non-volatile common memory 11 of the data processing unit 7 separately for each power supply path PSP. The stored measurement data can comprise current measurement data I-MDATA, voltage measurement data V-MDATA and temperature measurement data T-MDATA. The acquisition of measurement data can be triggered by different entities of the automation system comprising a control entity 15A of an application device 15 connected to the application device interface 3, a microcontroller 23 or FPGA of the data processing unit 7 or the external control cabinet controller 17 of the respective control cabinet 13. In a possible embodiment, a processor 12 of the data processing unit 7 can calculate a phase relationship between the different electrical AC power supply phases L1, L2, L3 supplied via the bidirectional internal power supply paths PSP1, PSP2, PSP3 of the Function Enhancement Control Cabinet Module 1. The processor 12 of the data processing unit 7 can be further adapted to determine or calculate a frequency f of the electrical AC power supply phases L1, L2, L3 based on the measurement data received by the data processing unit 7 from the measurement units 6-1, 6-2, 6-3 of the Function Enhancement Control Cabinet Module 1 as shown in the block diagram of Fig. 10. The processor 12 of the data processing unit 7 can be further adapted to calculate a real power, a reactive power and/or an apparent power for each phase L1, L2, L3. The processor 12 can further calculate a summed real, reactive and apparent power value for the multiphase power distribution system. The processor 12 can also calculate accumulated energy values related to single phases L-i or related to multiple phases of the multiphase power distribution system 14.

In a possible embodiment, the application device interface 3 comprises a motor controller to which an electrical motor is connected as a load device 21A. In a possible embodiment, the processor 12 of the data processing unit 7 is adapted to perform an automatic rotation field detection and/or an automatic polarity detection based on the measurement data MDATA stored in the data memory 11 of the data processing unit 7 for the different electrical AC power supply phases L1, L2, L3. The microcontroller 23 or FPGA of the data processing unit 7 can further perform a control function of the application device 15 connected to the application device interface 3 and the application device control interface 22 provided at the front side of the housing of the Function Enhancement Control Cabinet Module 1 through the application device interface 3 of the Function Enhancement Control Cabinet Module 1 as also illustrated in the block diagram of Fig. 8.

In a further possible implementation, the data processing unit 7 of the Function Enhancement Control Cabinet Module 1 can also comprise a microcontroller 23 or FPGA adapted to control at least one actuator provided within the bidirectional internal power supply paths PSP1, PSP2, PSP3 in response to the measurement data MDATA received by the data processing unit 7 from the measurement units 6-i of the Function Enhancement Control Cabinet Module 1 to optimize the power supply of the connected application device 15 and/or to provide protection of the application device 15 or its connected load device 21 such as the electrical multiphase motor against overcurrent and/or against overload. The actuator can comprise in a possible implementation a controllable semiconductor power switch or an electromechanical power switch such as a relay.

Fig. 8 shows the generalized internal structure of a Function Enhancement Control Cabinet Module 1 in a possible embodiment. As can be seen in the schematic block diagram of Fig. 8, the control interface 4 can also be provided to form a physical layer communication 25 of the microcontroller 23 of the Function Enhancement Control Cabinet Module 1. Further, the control interface 4 can be used to provide auxiliary power supply 27 and/or auxiliary input/output communication 26. In the illustrated implementation, the Function Enhancement Control Cabinet Module 1 also comprises a temperature measurement unit 28 comprising a temperature sensor 28A supplying temperature data sampled by an ADC 28B to the data processing unit 7. The analog to digital conversion units 10A, 10B are galvanically isolated by galvanic isolation means 24 from the data processing unit 7 of the Function Enhancement Control Cabinet Module 1 as shown in Fig. 8. Galvanic isolation can be achieved in a possible implementation by the provision of optical coupling elements, e.g. a light emitting diode receiving a signal from the ADC 10 and a light sensitive transistor connected to an input of the data processor 12 of the data processing unit 7. The data processing unit 7 communicates internally with the user visualization interface 5 and/or with the application device control interface 22 of the Function Enhancement Control Cabinet Module 1. In the illustrated embodiment of Fig. 8, a first set of voltage sensing elements 9A, 9B can be located at the side of the energy input interface 2. Depending on the use case and the kind of application device 15, a second set of voltage sensors 9B' can be added to measure also the voltage at the side of the application device interface 3. In this way, the state or health state of a load switch can be monitored by the data processing unit 7 of the Function Enhancement Control Cabinet Module 1.

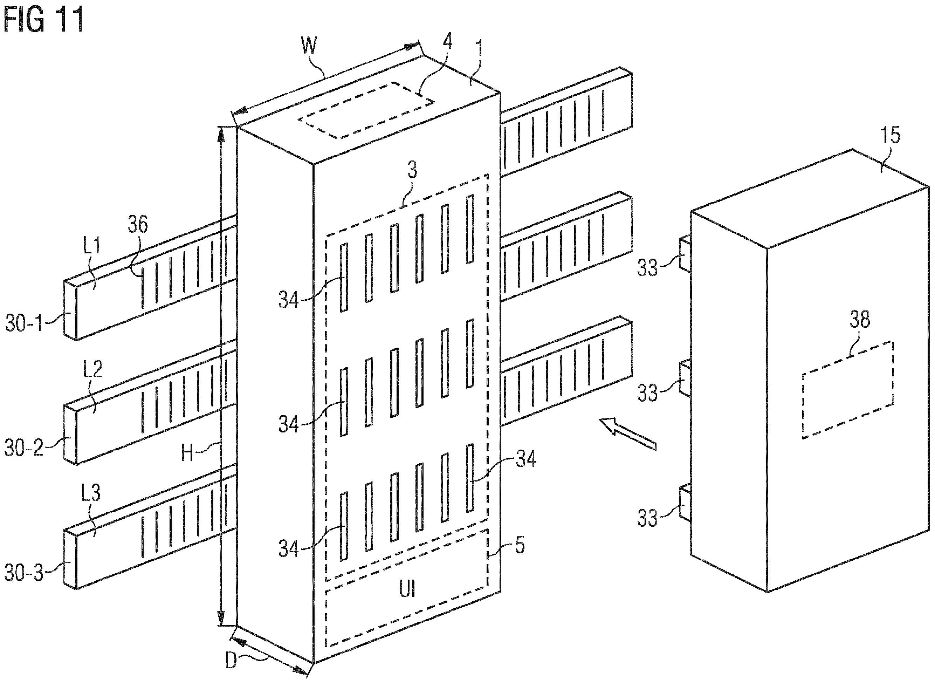

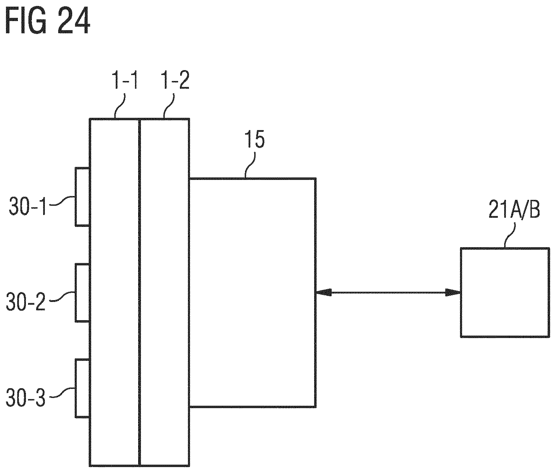

Fig. 11 shows a perspective view for illustrating a possible exemplary embodiment of a Function Enhancement Control Cabinet Module 1 according to the first aspect of the present invention having at least one energy interface 2 for connection of the Function Enhancement Control Cabinet Module 1 to a power distribution system 14 of the control cabinet 13. In the illustrated embodiment, the control cabinet 13 comprises a busbar power distribution system 14 with for instance three busbars 30-1, 30-2, 30-3 mounted in horizontal direction within the housing of the control cabinet 13 on a mounting platform. The energy interface 2 is provided at the rear side of the housing of the Function Enhancement Control Cabinet Module 1 as shown in Fig. 11 to provide electrical and mechanical connection to the busbars 30-1, 30-2, 30-3 of the control cabinet 13. On the opposite side of the housing, i.e. on the front side of the Function Enhancement Control Cabinet Module 1 as illustrated in Fig. 11, at least one application device interface 3 is provided which can be used for connection and power supply of at least one application device 15 connectable to the front side of the Function Enhancement Control Cabinet Module 1. The Function Enhancement Control Cabinet Module 1 can further comprise in the illustrated embodiment a control interface 4 which in the illustrated embodiment is provided on the top side of the housing of the Function Enhancement Control Cabinet Module 1 and can be used for connection to an external control cabinet controller 17 of the respective control cabinet 13. The Function Enhancement Control Cabinet Module 1 further comprises in the illustrated embodiment a user visualization interface 5 as shown in Fig. 11. The user visualization interface 5 can be provided at different locations of the housing of the Function Enhancement Control Cabinet Module 1 depending on the use case and may comprise light emitting diodes and/or display elements to display relevant information data to a user U. The user visualization interface 5 comprises in a preferred embodiment a touch sensitive user visualization interface 5 which allows to press sensitive portions of the user visualization interface 5 to input user commands. In the example illustrated in Fig. 11, the power distribution system 14 comprises a three-phase AC power supply system with three phases L1, L2, L3 distributed via corresponding busbars 30-1, 30-2, 30-3. In the illustrated example, the busbars 30 comprise slots 36 which can be used to receive protruding electrical contacts 29 provided at the rear side of the housing of the Function Enhancement Control Cabinet Module 1. In the same manner, the front side of the application device interface 3 can comprise slots 34 to receive protruding electrical contacts 33 of the application device 15 such as a motor controller used for controlling the power supply of a connected electrical motor. This allows to mount the Function Enhancement Control Cabinet Module 1 in a sandwiched position between the power distribution system 14 and the application device 15 in a plug and play manner. Further it is even possible to stack several Function Enhancement Control Cabinet Modules 1-1,1-2 upon each other as illustrated in Fig.24. The application device 15 can comprise a power supply connection interface 38 used for connecting the load device 21A to the respective application device 15.

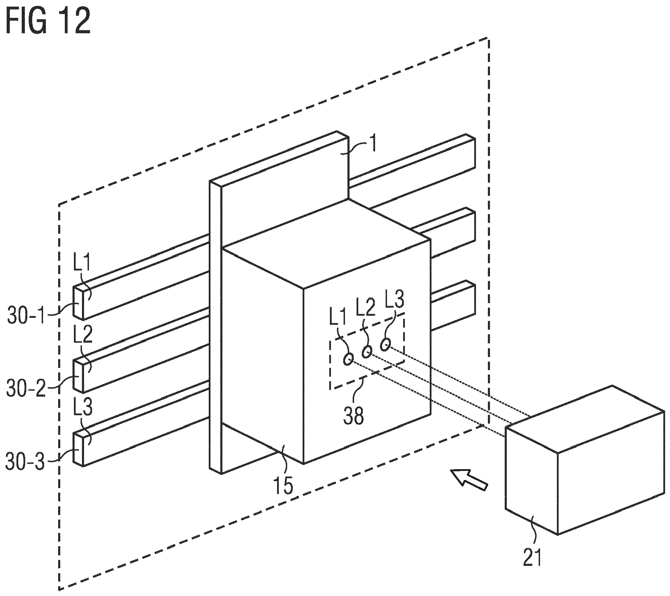

Fig. 12 illustrates a mounting of a load device 21 to the corresponding power supply generation interface 38 of the application device 15 already plugged into the application device interface 3 of the Function Enhancement Control Cabinet Module 1. As can be seen in Fig. 12, the Function Enhancement Control Cabinet Module 1 is sandwiched between the power distribution busbar system 14 comprising the busbars 30-1, 30-2, 30-3 for the different AC power phases L1, L2, L3 and the application device 15. In a possible preferred embodiment, the Function Enhancement Control Cabinet Module 1 can be removed such that the application device 15 is after the removal directly plugged into the busbars 30-1, 30-2, 30-3 of the power distribution system 14 of the control cabinet 13. Accordingly, only a predefined portion of the application devices 15 may be connected indirectly via associated sandwiched Function Enhancement Control Cabinet Modules 1 to the power distribution system 14 of the control cabinet 13. Another portion of the application devices 15 can be connected directly to the power distribution system 14 without using sandwiched Function Enhancement Control Cabinet Modules 1. This increases the flexibility of the automation system and allows to change the location of the Function Enhancement Control Cabinet Module 1 to provide measurement data for specific application devices 15, for instance for critical application devices 15 having critical load devices 21A requiring a real time monitoring of their operation states on the basis of the measurement data MDATA provided by the sandwiched Function Enhancement Control Cabinet Module 1 according to the present invention.

Fig. 13 shows a possible embodiment of the Function Enhancement Control Cabinet Module 1 used in a control cabinet 13 of the automation system. As can be seen in the illustrated embodiment, the energy interface 2 provided at the rear side of the housing of the Function Enhancement Control Cabinet Module 1 comprises electrical contacts 29 which are protruding from the rear side of the housing of the Function Enhancement Control Cabinet Module 1 and are pluggable into corresponding slots 36 of busbars 30 of the power distribution busbar system 14 of the control cabinet 13. The application device interface 3 at the front side of the housing of the Function Enhancement Control Cabinet Module 1 comprises in the illustrated embodiment of Fig. 13 at least one busbar portion of an internal busbar 31 included in the housing of the Function Enhancement Control Cabinet Module 1 and forming part of the internal bidirectional power supply path PSP. The busbar portion of the internal busbar 31 has slots 32 into which protruding electrical contacts 33 of the application device 15 can be plugged through associated contact openings 34 provided at the front side of the housing of the Function Enhancement Control Cabinet Module 1 shown in the cross section view of Fig. 13. As can be seen in Fig. 13, the measurement unit 6 and the data processing unit 7 are both integrated in the electrically isolating housing of the Function Enhancement Control Cabinet Module 1 and are provided on a printed circuit board PCB surrounded by the electrical isolating housing of the Function Enhancement Control Cabinet Module 1. The sensors 9 of the measurement unit 6 of the Function Enhancement Control Cabinet Busbar Module 1 shown in Fig. 13 are provided at the at least one internal busbar 31 included in the electrically isolating housing of the Function Enhancement Control Cabinet Busbar Module 1 to provide continuously or event-driven measurement data MDATA to the data processing unit 7 of the Function Enhancement Control Cabinet Busbar Module 1 indicating an amplitude or an amplitude change of the electrical current I flowing through the internal busbar 31 and/or indicating an electrical voltage or a voltage change at the internal busbar 31 of the Function Enhancement Control Cabinet Busbar Module 1. The energy interface 2 provided at the rear side of the housing of the Function Enhancement Control Cabinet Busbar Module 1 shown in Fig. 13 may comprise several electrical contacts for different AC power supply phases L of a multiphase power distribution busbar system 14 as also illustrated in Figs. 11, 12. In the illustrated embodiment of Fig. 13, the U-shaped internal busbar 31 is formed such that it surrounds at least partially the internal circuitry mounted on the printed circuit board PCB of the Function Enhancement Control Cabinet Busbar Module 1 shown in Fig. 13. This provides additional mechanical protection and does more importantly also use the required mounting space for the internal electronic circuitry efficiently thus minimizing the required size of the housing of the Function Enhancement Control Cabinet Busbar Module 1. In this way, the mounting space within the control cabinet 13 can be saved. The internal structure illustrated in Fig. 3 allows for a flat Function Enhancement Control Cabinet Busbar Module 1 as also illustrated in Figs. 11, 12. The housing of the Function Enhancement Control Cabinet Busbar Module 1 comprises a height H, a width W and a depth D. The structure of Fig. 13 allows for a small depth D of the Function Enhancement Control Cabinet Busbar Module 1 sandwiched between the power distribution system 14 and the application device 15. The width W of the housing of the Function Enhancement Control Cabinet Busbar Module 1 may correspond to the width W of the application device 15 as shown in Figs. 11, 12. In alternative embodiments, also several application devices 15 can be connected to the same Function Enhancement Control Cabinet Busbar Module 1 provided that the width W of the module housing is sufficient. Accordingly, several application devices 15 may share a common Function Enhancement Control Cabinet Busbar Module 1 such as application devices 15-5 shown in Fig.28.

Fig. 14 illustrates the internal structure of the Function Enhancement Control Cabinet Busbar Module 1 as shown in the cross-sectional view of Fig. 13. Fig. 14 shows the internal busbar 31 with the front busbar portion having slots 32 and the rear side protruding contacts 29 used for plug-in the Function Enhancement Control Cabinet Module 1 in corresponding slots 36 of busbars 30 of the power distribution system 14. In the illustrated embodiment of Fig. 14, the upper portion shown in Fig. 14 forms the application device interface 3 and the lower portion shown in Fig. 14 forms the energy interface 2.

Fig. 15 illustrates a printed circuit board PCB with the electronic components of the measurement unit 6 and of the data processing unit 7. For each phase L of the multiphase AC power distribution system 14, a corresponding internal busbar portion of an internal busbar 31 is provided and can be used for connecting a phase L of the respective application device 15.

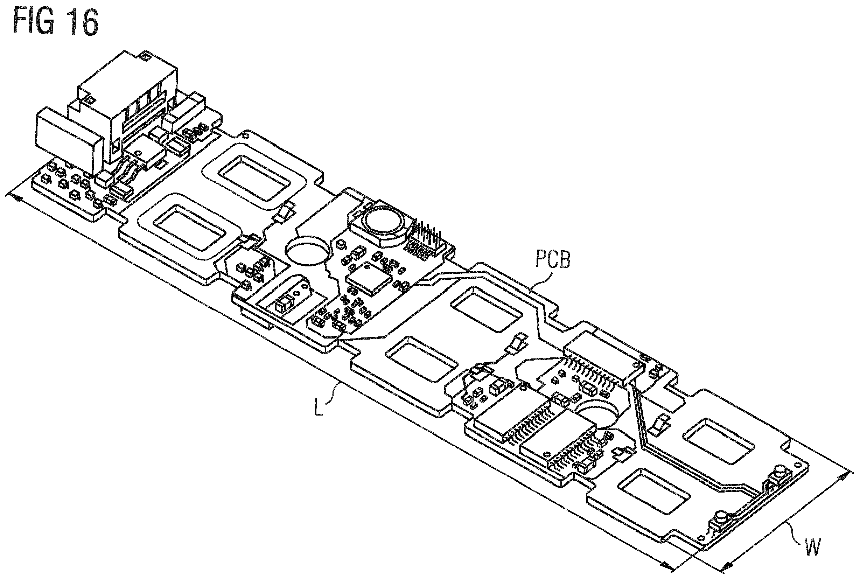

Fig. 16 illustrates the printed circuit board PCB with removed internal busbars 31. The printed circuit board PCB with the electronic components comprises a length L and a width W corresponding to the height H and width W of the flat Function Enhancement Control Cabinet Busbar Module 1 illustrated in Figs. 11, 12. In a possible implementation, the printed circuit board PCB along with the connected internal busbars 31 can be inserted into the housing of the Function Enhancement Control Cabinet Busbar Module 1 through a mechanical reception interface as also illustrated in Fig. 25. This allows to replace the printed circuit board PCB even when the Function Enhancement Control Cabinet Busbar Module 1 is mounted in a sandwiched position between the power distribution system 14 of the control cabinet 13 and the application device 15. In a possible implementation, a sensor 9 provided at the internal power supply path PSP is adapted to generate a sensor signal supplied via gold spring elements or via spring elements made of another corrosion resilient material of the data processing unit 7 mounted on the printed circuit board PCB of the Function Enhancement Control Cabinet Busbar Module 1.

In a possible implementation, the application device 15 connected to the application device interface 3 provided at the front side of the housing of the Function Enhancement Control Cabinet Busbar Module 1 can comprise an RFID tag, storing application device identification data and/or device operation boundary data. The application device identification data and/or the device operation boundary data of the application device 15 can be read in a possible implementation by an RFID reading unit of the Function Enhancement Control Cabinet Busbar Module 1 and supplied to the processor 12 of the data processing unit 7 of the Function Enhancement Control Cabinet Busbar Module 1 and stored in a local non-volatile data memory 11 of the data processing unit 7 for further processing.

Figs. 18A, 18B illustrate exemplary implementations for a possible mounting of a Function Enhancement Control Cabinet Module 1 according to the present invention to a busbar 30 of a power distribution system 14 of the control cabinet 13. Fig. 18A illustrates an implementation where a hook-shaped contact 39 provided at the rear side of the housing of the Function Enhancement Control Cabinet Module 1 is used for mounting a module on the respective busbar 30 and provide at the same time an electrical contact to the busbar 30. In the alternative implementation illustrated in Fig. 18B, protruding electrical contacts 29 of the energy interface 2 provided at the rear side of the housing of the Function Enhancement Control Cabinet Module 1 are plugged into corresponding slots 36 of the illustrated busbar 30 of the power distribution system 14.

Fig. 19 shows a further exemplary implementation of a possible connection of a Function Enhancement Control Cabinet Module 1 to a power distribution system 14 of a control cabinet 13. In the illustrated embodiment, the rear side of the housing of the Function Enhancement Control Cabinet Module 1 comprises a contour or engaging elements 40 which can be used to mount the housing of the Function Enhancement Control Cabinet Module 1 to a mounting rail 41 such as a hut rail of the mounting platform of the control cabinet 13. In the illustrated example, the mounting rail 41 is connected to a mounting plate 42 of the control cabinet 13. Also, on the front side of the housing of the Function Enhancement Control Cabinet Module 1, a mounting rail 43 can be used for mounting an application device 15 to the Function Enhancement Control Cabinet Module 1. This implementation can be provided for connection of the application device 15 to the application device interface 3 which is provided in the illustrated exemplary embodiment on the top side of the housing of the Function Enhancement Control Cabinet Module 1. In the illustrated embodiment, the energy supply interface 2 can be provided at the lower side of the housing. Accordingly, in different embodiments, the different interfaces 2, 3, 4, 5 of the Function Enhancement Control Cabinet Module 1 may be located on different sides of the housing of the Function Enhancement Control Cabinet Module 1.

Both sensing and communication capabilities of the Function Enhancement Control Cabinet Module 1 allow in a preferred embodiment for a standardized communication with an external cabinet controller 17 of the control cabinet 13 such as a PLC via a control cabinet bus system 16 without requirement of wiring the application device 15 to the PLC of the control cabinet 13. This greatly eases the setup of a control cabinet 13 and/or of the automation system shown in Fig. 9 since only a fraction of the wires are required in contrast to a classical approach of a conventional control cabinet 13. In addition, less wires allows a user to more easily understand the automation system thus allowing for more expedient extension or modification of the automation system.

The Function Enhancement Control Cabinet Module 1 provides for a more comprehensive monitoring of the application side. Also, detailed information and measurement data of the energy input side is available. This covers for example also voltage levels and/or i.e. rotational field detection related to a multiphase AC power distribution system of the control cabinet 13.

Further, in case that environmental parameters have changed compared to a recent work cycle, a user U and/or a control cabinet controller 17 can be informed about this specific issue. In this way, repair and maintenance work can be facilitated, in particular thanks to the user visualization interface 5 of the Function Enhancement Control Cabinet Module 1. In a possible embodiment, the user visualization interface 5 can comprise a set of light emitting diodes LEDs located at the side of the application device interface 3 and adapted to indicate a connection state and/or an operation state of an application device 15 connected to the application device interface 3 of the Function Enhancement Control Cabinet Busbar Module 1. The Function Enhancement Control Cabinet Busbar Module 1 can further comprise a second set of light emitting diodes LEDs located at the side of the energy supply interface 3 and adapted to indicate a connection state and/or an operation state of the power distribution busbar system 14 connected to the energy supply interface 2 of the Function Enhancement Control Cabinet Busbar Module 1. Accordingly, if a critical operation state occurs on the side of the energy interface 2, a corresponding set of LEDs can make a user U aware of the problem residing on the energy supply side of the Function Enhancement Control Cabinet Module 1. In contrast, if the other opposing set of LEDs on the other side of the housing of the Function Enhancement Control Cabinet Module 1 indicates a critical state, a user U becomes aware that the problem or failure is most likely at the application side of the Function Enhancement Control Cabinet Module 1.

With the Function Enhancement Control Cabinet Module 1 according to the present invention, a control cabinet controller 17 such as a PLC or a system level controller of the automation system can be fed with detailed information and data about a specific load device 21 controlled via an application device 15 and a Function Enhancement Control Cabinet Module 1 connected to the power distribution system 14 of the control cabinet 13. Besides the provision of instantaneous measurement values or measurement data MDATA, the Function Enhancement Control Cabinet Module 1 according to the present invention allows also to monitor a long-term drift of measurement values or measurement data MDATA. If a significant or abrupt change of data is detected, the cabinet controller 17 can be informed instantaneously. Additionally, user information can be presented to a user U by means of the user visualization interface 5.

The application device 15 connected to the application device interface 3 can comprise in a possible simple application a non-switchable load connector providing a connection between the application device interface 3 and the load device 21. The Function Enhancement Control Cabinet Module 1 provides temperature monitoring as well as voltage and current measurements or profiles to monitor the operation of the connected load.

In a further exemplary use case, the application device 15 can comprise an unfused load switch. In a possible embodiment, the state of the switch can be notified to the data processing unit 7 of the Function Enhancement Control Cabinet Module 1, for instance via a small auxiliary switch or a light barrier. In case a user U can only operate the load switch manually, the state is in this case known to the overall automation system. Consequently, in this use case, a supervision of the switch also becomes possible, since the load current I is only allowed to flow if the switch is in a closed position.

In some use cases, the load devices 21A connected to the power distribution system 14 require fusing. The fuses can be typically located on specific products mounted on a busbar adapter. Following the previous examples, now a fused, manually operated load switch is discussed. In this case, it is of interest to also monitor the state of the fuses. This can be done in several ways as follows. If a fuse has blown a significant voltage will drop over the respective fuse element. This can be detected by performing a different voltage measurement over the fuse contacts. In a possible embodiment, the sensed voltage is fed to an RFID tag of the application device 15. The data in turn is read out by the Function Enhancement Control Cabinet Module 1. Also, feeding the sensed voltage to a photocoupler providing this information with classical wiring to the Function Enhancement Control Cabinet Module 1 is possible. Further, the use of two sets of voltage sensor elements can provide the same functionality. The first set of sensors is connected to the feeding side of the fuses and the second set of sensors is connected on a load side of the fuses.

In a further alternative implementation, a monitoring algorithm executed by the data processing unit 7 is adapted to monitor a fuse stress of fuse elements based on a load current as well as on the basis of a stored load current history. For providing this way of fuse monitoring, the Function Enhancement Control Cabinet Module 1 does know the type and rating of the used fuses. Further, the fuses can also be provided with an RFID tag which may hold this kind of information about the type and reading. This overcomes the problem that wrong parameters may be entered by a user which may affect the sensitivity of the detection algorithm.

In a possible embodiment, the application device interface 3 of the Function Enhancement Control Cabinet Module 1 is also capable of driving contactors or solid-state relays. The Function Enhancement Control Cabinet Module 1 can also be adapted in a possible embodiment to evaluate a state of auxiliary inputs. With the automation system according to the present invention employing the Function Enhancement Control Cabinet Module 1, different kinds of automated or electrical controllable load switches can be set up. The measurement capabilities allow also for a very specific load protection including a motor protection algorithm. The application device 15 may comprise a motor controller or motor starter. By the use of the Function Enhancement Control Cabinet Module 1, motor starter applications become quite smart because the Function Enhancement Control Cabinet Module 1 also provides electrical current monitoring for overload protection. Due to the software implementation of a motor protection algorithm, it is possible that the data processing unit 7 is able to adjust rated electrical current and trip class settings.

If a reversing motor starter is required two contactors can be used on the application device side. Communication to the control cabinet controller 17 can be done through the control interface 4 of the Function Enhancement Control Cabinet Module 1. Also, contactor drive and monitoring via an auxiliary switch can be performed by the Function Enhancement Control Cabinet Module 1.

In a use case where a high frequency switching is desired, solid-state relays can be used instead of classical contactors. Also, in this use case, driving and monitoring the switching elements can be performed by the Function Enhancement Control Cabinet Module 1 according to the present invention. The Function Enhancement Control Cabinet Module 1 can also provide efficient short circuit protection with minimum delay times and/or an overcurrent protection by controlling actuators, in particular semiconductor power switches provided in the power supply path PSP.

Conventional automation system applications are normally set up once and remain unchanged during a long life cycle of the automation system. Thanks to the flexible connector structure, the Function Enhancement Control Cabinet Module 1 can also provide assistance for maintenance, repair and troubleshooting within the automation system. For example, a user U can detect an increasing amount of errors or defects or failures on a subpart of the automation system. By using the Function Enhancement Control Cabinet Module 1 it is possible to add and insert the flat Function Enhancement Control Cabinet Module 1 in a plug-and-play manner to a specific load connection for further investigation.

Depending on the application or use case, the user U of the control cabinet 13 can start a recording of the voltage V and electrical current I at the power supply paths PSPs of the Function Enhancement Control Cabinet Module 1 and acquire data related to the event of interest.

Also, a control entity connected via control wires to the application device control interface 22 can be used to trigger and control data acquisition.

Depending on the scope of the data analysis or whether a storage of recorded data and events in a local non-volatile memory 11 of the Function Enhancement Control Cabinet Module 1 is desired, the user U uses a PC application to get a real-time view on the assistance status or events of interest based on the stored data. Measurement data MDATA and other data such as the identification data can be logged during the operation of the automation system.

With increasing complexity of the automation system, also the tasks of ensuring availability and planning maintenance of entities within the automation system become more complicated. The Function Enhancement Control Cabinet Module 1 provides efficient real-time data allowing a seamless, robust and reliable monitoring of different entities within the automation system.

Whether a specific defect or failure can be predicted depends on the specific application. In any case, a lot of processes performed in an automation system comprise patterns that repeat itself very often. With the Function Enhancement Control Cabinet Module 1 comprising in a possible embodiment a trained artificial neural network ANN, it is possible to auto-discover specific data patterns and events occurring in the monitored automation system.

The internal structure of the Function Enhancement Control Cabinet Module 1 provides all necessary components or elements to run specific algorithms directly on the data processing unit 7 of the Function Enhancement Control Cabinet Module 1. These algorithms can be performed by a processor 12 of the data processing unit 7 including the acquiring of measurement data MDATA, the preprocessing of measurement data MDATA the correlation of measurement data MDATA with each other and comparing the measurement data MDATA with previously stored measurement data MDATA and/or with measurement data MDATA provided by other Function Enhancement Control Cabinet Modules 1 of the control cabinet identified by their FMCCI-IDs. The evaluation of the measurement data MDATA is facilitated in a possible embodiment by a common time grid provided by a distributed clock signal CLK of the control cabinet 13.

In a possible embodiment, after some work cycles, the controller or artificial neural network ANN within the data processing unit 7 of the Function Enhancement Control Cabinet Module 1 does learn how for instance electrical current patterns drawn by a specific electrical motor connected as a load 21 via an application device 15 to the Function Enhancement Control Cabinet Module 1 will look like. For instance, if it can be seen from a long-term drift of the sampled values that the electrical motor current tends to increase, a revision and/or cleaning of the pump or other machine driven by the electrical motor can be necessary. In this way, the maintenance and repair scheduling of entities within the automation system can be simplified.

In this case, a flowmeter on the fluid side of a pump driven by the electrical motor can be added. In this use case, a direct correlation between the amount of fluid and the electrical motor current I can be recorded using the Function Enhancement Control Cabinet Module 1 according to the present invention. Again, the data processing unit 7 of the Function Enhancement Control Cabinet Module 1 can be trained on typical working cycles.

In case that some unexpected behavior is detected, for instance by the trained artificial neural network ANN, the electrical motor as a load device 21A can be stopped automatically in response to a control command or a control signal CRTL output by the data processing unit 7 through the application device control interface 22 to the control entity of the electrical motor. Simultaneously, a user U can be notified about the motor failure through the user visualization interface 5 of the Function Enhancement Control Cabinet Module 1. In most cases, defects or failures of a component of the automation system do not occur suddenly but a degradation of the system or a system component takes slowly place over time. With the evaluation of the measurement data MDATA, it is possible to perform predictive maintenance and to plan maintenance activities before the affected equipment or application device 15 or load device 21A completely fails. In another use case where an electrical switching equipment is used, a voltage drop during on-state, a switching transition time and leakage current in the off-state can provide insight to a switch health status. The Function Enhancement Control Cabinet Module 1 provides the necessary sensing elements 9 within the measurement unit 6 to determine the momentary health status of most kinds of electrical switching equipment.

The Function Enhancement Control Cabinet Module 1 can be used in a wide variety of different automation systems and for different kinds of application devices 15 and control cabinets 13.

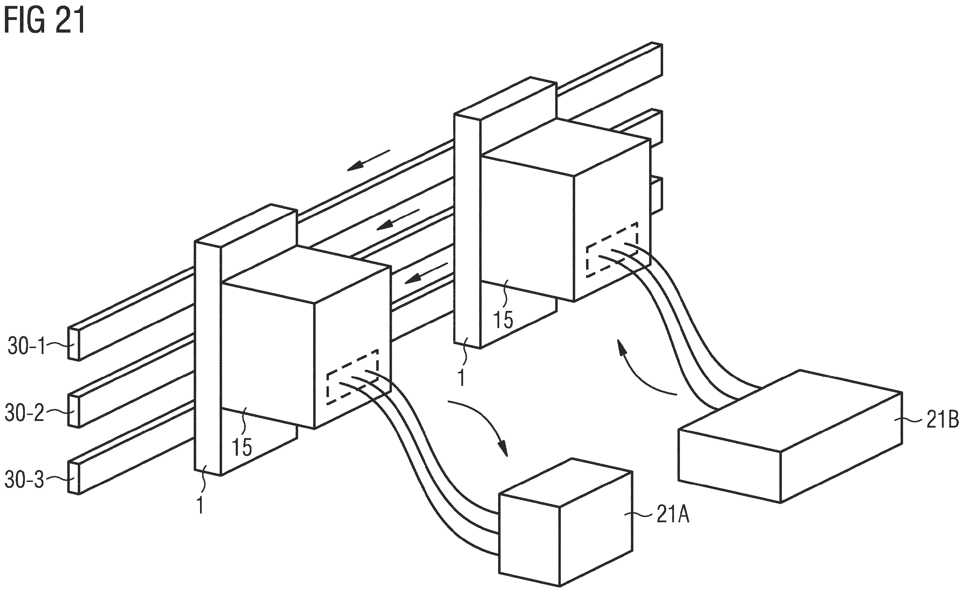

The Function Enhancement Control Cabinet Module 1 according to the present invention comprises a bidirectional internal power supply path PSP. Accordingly, it is possible to connect both power-consuming load devices 21A but also power generation devices 21B to corresponding application devices 15 as illustrated in Fig. 21. As can be seen in Fig. 21, a local power generation device 21B which may be mounted in the control cabinet 13 can be used for a local power supply of a neighboring power-consuming load device 21A through Function Enhancement Control Cabinet Modules 1 sandwiched between busbars 30-i of a power distribution system 14 and the application devices 15 as shown in Fig. 21. The power generation device 21B can for instance be a battery mounted in the control cabinet 13 which can be used as an emergency energy source in case that an external power supply to the control cabinet 13 fails. In this embodiment, the power-consuming load device 21A receives its power supply from the local power generation device 21B through the Function Enhancement Control Cabinet Modules 1 connected to the busbars 30-i of the power distribution system 14 as shown in Fig. 21. In an alternative embodiment, the power generation device 21B can also comprise an AC power source such as a generator which may be activated when the external power supply fails. In a possible implementation, the Function Enhancement Control Cabinet Modules 1 are notified by the controller 17 of the control cabinet 13 in case that a power supply to the control cabinet 13 is interrupted. In a possible embodiment the FECCM 1 can measure the supply voltage at the busbars 30-i of the power distribution system 14 and may notify the controller 17 of the control cabinet 13 for instance as soon as the supply voltage is missing. The controller 17 of the control cabinet 13 can switch the power supply path PSP of the Function Enhancement Control Cabinet Module 1 connected to the power-consuming load device 21A into a forward power supply direction and the power supply path PSP of the other Function Enhancement Control Cabinet Module 1 connected to the power generation device 21B into a reverse power supply direction such that the electrical current I generated by the power generation device 21B is transferred via a first application device 15 and its Function Enhancement Control Cabinet Module 1 through the busbars 30 and the other Function Enhancement Control Cabinet Module 1 and its application device 15 to reach finally the power-consuming load device 21A as shown in Fig. 21. If the busbars 30 shown in Fig.21 are for integrated in a touch protection busbar board of the power distribution system as shown in Fig.28 the power generation device 21B may provide a substitute power supply for the power consuming load device 21A in case that the busbar board is removed temporarily from the local power distribution system of the control cabinet.

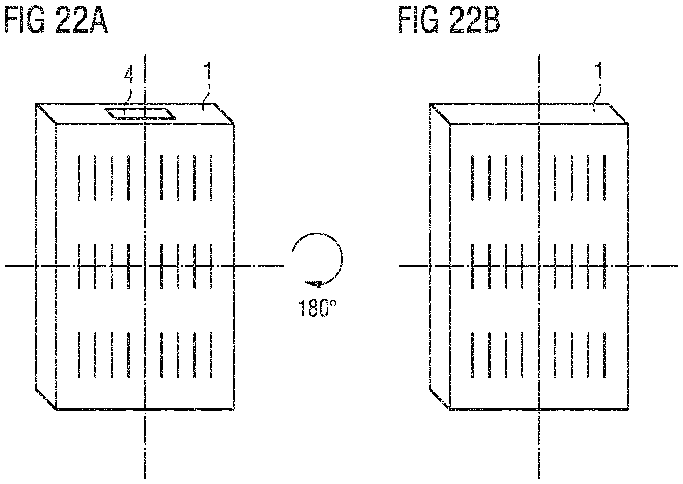

Figs. 22A, 22B show a housing of a Function Enhancement Control Cabinet Module 1 according to the present invention. In the illustrated embodiment, it can be seen that the housing of the Function Enhancement Control Cabinet Module 1 is symmetrical and can be turned along its longitudinal axis by 180°. This allows that the control interface 4 visible in Fig. 22A can always be directed towards the controller 17 of the control cabinet 13. This does facilitate the wiring between the Function Enhancement Control Cabinet Module 1 and the controller 17 of the control cabinet 13 via the internal bus 16 of the control cabinet 13.

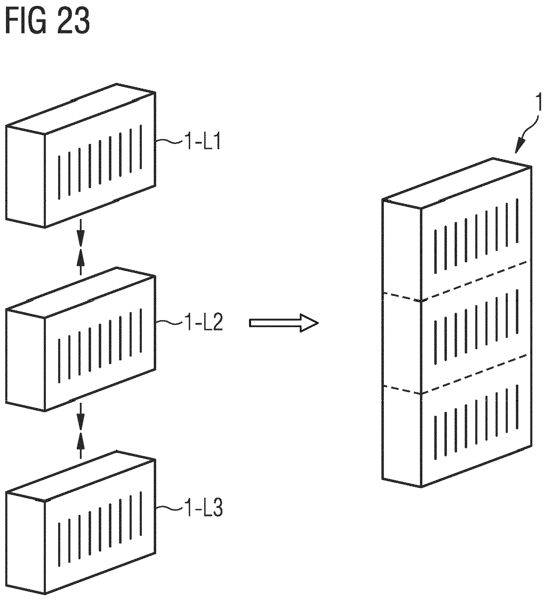

Fig. 23 illustrates a further exemplary embodiment of a Function Enhancement Control Cabinet Module 1 according to the present invention. In the illustrated embodiment of Fig. 23, the Function Enhancement Control Cabinet Module 1 is a multiphase Function Enhancement Control Cabinet Busbar Module 1 composed of three single-phase Function Enhancement Control Cabinet Modules 1. In the illustrated example, the first single-phase Function Enhancement Control Cabinet Busbar Module 1-L1 is provided for a first phase L1 of a multiphase power distribution system 14, the second single-phase Function Enhancement Control Cabinet Busbar Module 1-L2 is provided for a second phase L2 of a multiphase power distribution system 14 and the third single-phase Function Enhancement Control Cabinet Busbar Module 1-L3 is provided for a third phase L3 of a multiphase power distribution system 14. By plugging the three separate single Function Enhancement Control Cabinet Busbar Modules 1 shown on the left side of Fig. 23 together, a three-phase Function Enhancement Control Cabinet Module 1 is created which can be used for three phases of a three-phase power supply system. Accordingly, Fig. 23 shows the modular composition of a multiphase Function Enhancement Control Cabinet Module 1. In this way, the flexibility of the system can be increased and multiphase Function Enhancement Control Cabinet Modules 1 can be created by a user U by plugging available single-phase Function Enhancement Control Cabinet Modules 1 together as illustrated schematically in Fig. 23. Each single-phase Function Enhancement Control Cabinet Module 1 shown in Fig. 23 can include an associated measurement unit 6 and an integrated data processing unit 7 provided between a single-phase energy interface 2 and a single-phase application device interface 3 as also illustrated schematically in the block diagram of Fig. 1. Further, each single-phase Function Enhancement Control Cabinet Module 1 shown in Fig. 23 may comprise a control interface 4 and a user visualization interface 5. Other embodiments are possible. For instance, one of the three single-phase Function Enhancement Control Cabinet Modules 1-L1, 1-L2, 1-L3 forms a basic single-phase Function Enhancement Control Cabinet Module 1 having a control interface 4 and a user visualization interface 5 whereas the added single-phase Function Enhancement Control Cabinet Modules 1 may only comprise an associated energy interface 2 and an associated application device interface 3.

Fig. 24 shows a further possible use case for a Function Enhancement Control Cabinet Module 1 according to the present invention. As can be seen in Fig. 24, several Function Enhancement Control Cabinet Modules 1-i can be stacked upon each other between a power distribution system 14 of the control cabinet 13 and an application device 15. The reason for stacking can be that for instance the Function Enhancement Control Cabinet Modules 1-1-, 1-2 shown in Fig. 24 may comprise different sensor components 9 which provide different kinds of measurement data MDATA (e.g. I-MDATA, V-MDATA). Another reason for stacking can be the need to provide redundancy. For instance if a load is critical or highly sensitive a redundant monitoring by two or more stacked FECCMs 1-i providing the same kind of measurement data can be performed. Further, the different Function Enhancement Control Cabinet Modules 1-i stacked between the power distribution system 14 and the application device 15 can comprise in a possible embodiment different processing capabilities to evaluate measurement data MDATA. In a possible embodiment, the first Function Enhancement Control Cabinet Module 1-1 may for instance generate current measurement data I-MDATA whereas the other stacked Function Enhancement Control Cabinet Module 1-2 generates voltage measurement data V-MDATA. Each stacked Function Enhancement Control Cabinet Module 1-i shown in Fig. 24 can comprise in a possible embodiment an integrated measurement unit 6 and an integrated data processing unit 7. By stacking the Function Enhancement Control Cabinet Modules 1-i between the power distribution system 14 of the control cabinet 13 and the application device 15, even more flexibility for addressing the respective use case can be achieved.

Fig. 25 shows a further possible exemplary embodiment of a Function Enhancement Control Cabinet Busbar Module 1. In the illustrated embodiment, the housing of the Function Enhancement Control Cabinet Busbar Module 1 comprises at a sidewall reception means which allows to replace a printed circuit board PCB onto which the different internal busbars 30-i are fixed. The embodiment illustrated in Fig. 25 allows to replace a printed circuit board PCB with the corresponding circuitry, i.e. the measurement unit 6 and the data processing unit 7, by another printed circuit board PCB with another measurement unit 6 and another data processing units 7. This replacement can even take place in a possible embodiment when the Function Enhancement Control Cabinet Busbar Module 1 shown in Fig. 25 is sandwiched between the power distribution system 14 of the control cabinet 13 and the application device 15. Accordingly, an application device 15 mounted on the front side of the housing of the Function Enhancement Control Cabinet Busbar Module 1 as shown in Fig. 25 has not to be taken off for a replacement of the internal circuitry of the Function Enhancement Control Cabinet Busbar Module 1.

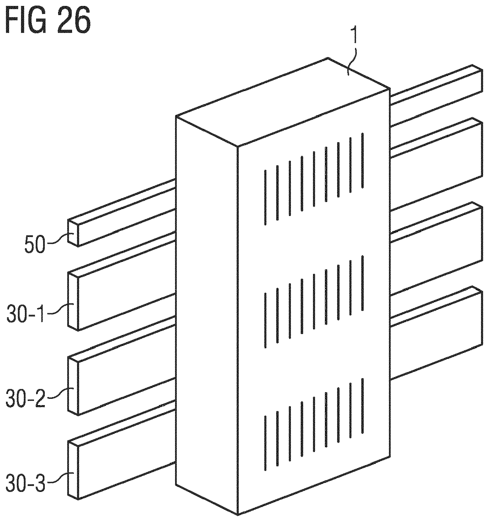

Fig. 26 illustrates a further exemplary embodiment of a Function Enhancement Control Cabinet Busbar Module 1 according to the present invention. In the illustrated embodiment, there is a further communication busbar 50 provided which allows a separate communication with other Function Enhancement Control Cabinet Busbar Modules 1 of the control cabinet 13. Fig. 26 shows three power supply busbars 30-1, 30-2, 30-3 of a power distribution system 14 of the control cabinet 13 and a separate communication busbar 50 which can be used for communication of the data processing unit 7 of the Function Enhancement Control Cabinet Busbar Module 1 shown in Fig. 26 with other entities of the control cabinet 13, in particular with the data processing units 7 of other Function Enhancement Control Cabinet Modules 1 mounted on the power distribution system 14 and connected to the same communication busbar 50.

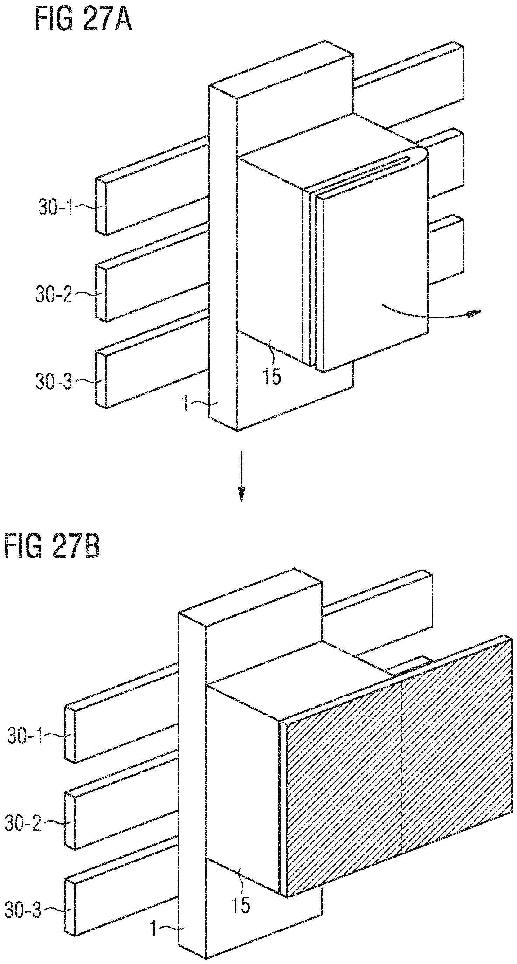

Figs. 27A, 27B show a further exemplary embodiment of an application device 15 connected to the front side of a Function Enhancement Control Cabinet Module 1 according to the present invention. In the illustrated embodiment, the application device 15 comprises a foldable graphical user interface GUI. The graphical user interface GUI illustrated in Fig. 27A is unfolded to increase the available display area as shown in Fig. 27B.

In a possible embodiment, the user visualization interface 5 of the Function Enhancement Control Cabinet Busbar Module 1 comprises also a display unit having a foldable display area. In this way, more complex information concerning the Function Enhancement Control Cabinet Busbar Module 1 and the application device 15 or its connected load device 21A or connected power source 21B can be displayed to a user U of the control cabinet 13.

Fig. 28 illustrates a perspective view on a busbar board comprising a plurality of different application devices 15 connected to the busbar board through corresponding Function Enhancement Control Cabinet Busbar Modules 1 according to the present invention. In the illustrated embodiment of Fig. 28, a first Function Enhancement Control Cabinet Busbar Module 1-1 does not carry an associated application device 15. The Function Enhancement Control Cabinet Busbar Modules 1-1, 1-2, 1-3 each carry a single associated application device 15-2, 15-3, 15-4. The fifth Function Enhancement Control Cabinet Busbar Module 1-5 carries two application devices 15-5. The sixth Function Enhancement Control Cabinet Busbar Module 1-6 illustrated in Fig. 28 carries an adapter device 15-6 as an application device.

Any application device 15-i as illustrated in Fig. 28 can also be connected directly to the busbars 30 integrated in the busbar board without the provision of a sandwiched Function Enhancement Control Cabinet Busbar Module 1-i in case that no measurement data MDATA is required, in particular if the load device 21A connected to the respective application device 15-i does not form a critical component of the automation system.

In a possible embodiment the busbar board 47 shown in Fig.28 can be mounted to a rear side power supply module of the power distribution system 14 adapted to provide a power supply of the busbar board 49 from a rear side of the busbar board 49. The busbar board 49 can be mounted without requiring use of a tool to protruding touch protected and lyre shaped contacts of the rear side power supply module enclosing in the mounted position sidewalls of U-shaped busbars 30 integrated in the busbar board 49.

## Claims

1. A Function Enhancement Control Cabinet Busbar Module, FECCM, (1) comprising:
at least one internal bidirectional power supply path, PSP, provided between an energy interface (2) at a rear side of a housing of the Function Enhancement Control Cabinet Busbar Module, FECCM, and the application device interface (3) provided at a front side of the housing of the Function Enhancement Control Cabinet Busbar Module, FECCM, (1) and adapted to feed electrical power in a forward power supply direction from at least one busbar (30) of a power distribution busbar system (14) connected to the energy interface (2) to the application device (15) connected to the application device interface (3) or is adapted to feed electrical power in a reverse power supply direction from the application device (15) connected to the application device interface (3) to at least one busbar (30) of the power distribution busbar system (14) connected to the energy interface (2); and
at least one measurement unit, MU, (6) integrated in the housing of the Function Enhancement Control Cabinet Busbar Module, FECCM, (1) and provided at the internal power supply path, PSP, between the energy interface (2) and the application device interface (3) to provide measurement data, MDATA, to a data processing unit, DPU, (7) integrated in the housing of said Function Enhancement Control Cabinet Busbar Module, FECCM, (1) wherein said data processing unit, DPU, (7) is galvanically isolated from said measurement unit, MU, (6) and is adapted to exchange control information and data with an external controller connected to a control interface (4) of the Function Enhancement Control Cabinet Busbar Module, FECCM, (1) provided in the housing of the Function Enhancement Control Cabinet Busbar Module, FECCM, (1) and connected to the integrated data processing unit, DPU, (7) of the Function Enhancement Control Cabinet Busbar Module, FECCM, (1).

2. The Function Enhancement control Cabinet Busbar Module, FECCM, according to claim 1, further comprising a user visualization interface (5) to provide feedback to a user by means of Light Emitting Diodes, LEDs, or by means of an integrated display unit.

3. The Function Enhancement Control Cabinet Busbar Module, FECCM, according to claim 1 or 2 wherein the measurement unit, MU, (6) integrated in the housing of the Function Enhancement Control Cabinet Busbar Module, FECCM, (1) comprises
one or more sensors (9) including
at least one current sensor (9A) adapted to measure an electrical current, I, flowing through the power supply path, PSP, and/or including
at least one voltage sensor (9B) adapted to measure an electrical voltage, V, at the energy interface (2) provided at the rear side of the housing of the Function Enhancement Control Cabinet Busbar Module, FECCM, (1) and/or at the application device interface (3) provided at a front side of the housing of the Function Enhancement Control Cabinet Busbar Module, FECCM, (1) and/or including
at least one temperature sensor (28A) adapted to measure a temperature, T, inside the housing of the Function Enhancement Control Cabinet Busbar Module, FECCM, (1), wherein the current sensor (9A), the voltage sensor (9B) and the temperature sensor (28A) are adapted to provide the galvanically isolated data processing unit, DPU, (7) of the Function Enhancement Control Cabinet Module, FECCM, (1) with corresponding measurement data, MDATA.

4. The Function Enhancement Control Cabinet Busbar Module, FECCM, according to claim 3
wherein the current sensor (9A) of the measurement unit, MU, (6) being adapted to measure the electrical current, I, flowing through the internal power supply path, PSP, comprises at least one shunt resistor, or a Hall sensor, or a current transformer or a Rogowski coil and is adapted to provide a current sensor signal sampled with a predetermined or adjustable sampling rate, SR, and converted by a first analog to digital converter, ADC1, (10A) of the measurement unit, MU, (6) to generate current measurement data, I-MDATA, supplied by the measurement unit, MU, (6) to the data processing unit, DPU, (7) of the Function Enhancement Control Cabinet Busbar Module, FECCM, (1) and/or stored in a local non-volatile data memory (11) of the data processing unit, DPU, (7) as a current profile,I-PROFILE,
wherein the voltage sensor (9B) of the measurement unit, MU, (6) is adapted to measure the electrical voltage, V, at the internal power supply path, PSP, and is adapted to provide a voltage sensor signal sampled with a predetermined or adjustable sampling rate,SR, and converted by a second analog to digital converter, ADC2, (10B) of the measurement unit, MU, (6) to generate voltage measurement data, V-MDATA, supplied by the measurement unit, MU, (6) to the data processing unit, DPU, (7) of the Function Enhancement Control Cabinet Busbar Module, FECCM, (1) and/or stored in a local non-volatile data memory (11) of the data processing unit, DPU, (7) as a voltage profile,V-PROFILE, and
wherein the temperature sensor (28A) of the measurement unit, MU, (6) is adapted to measure a temperature, T, at the internal power supply path, PSP, provided within the housing of the Function Enhancement Control Cabinet Busbar Module, FECCM, (1) and to supply a corresponding temperature measurement signal to a third analog to digital converter, ADC3, (28B) of the measurement unit, MU, (6) adapted to sample the temperature measurement signal with a predetermined or adjustable sampling rate, SR, to generate temperature measurement data, T-MDATA, supplied to the data processing unit, DPU, (7) of the Function Enhancement Control Cabinet Busbar Module, FECCM, (1) and/or stored in a local non-volatile data memory (11) of the data processing unit, DPU, (7) as a temperature profile,T-PROFILE.

5. The Function Enhancement Control Cabinet Busbar Module, FECCM, according to claim 2 to 4 wherein the user visualization interface (5) which is connected to the data processing unit, DPU, (7) of the Function Enhancement Control Cabinet Busbar Module, FECCM,(1) and is adapted to display an application device operation state, in particular an operation failure state, of the at least one application device (15) connected to the application device interface (3) provided at the front side of the housing of the Function Enhancement Control Cabinet Busbar Module, FECCM, (1) and/or to display a power supply state of the power distribution busbar system (14) connected to the energy interface (2) provided at the rear side of the housing of the Function Enhancement Control Cabinet Busbar Module, FECCM, (1)and/or to display information about an internal system state of the Function Enhancement Control Cabinet Busbar Module, FECCM,(1).

6. The Function Enhancement Control Cabinet Busbar Module, FECCM, according to any of the preceding claims 1 to 5 wherein the power distribution busbar system (14) comprises an AC power distribution busbar system having at least one busbar (30) for an associated AC power supply phase, L, applied to a corresponding electrical contact of the energy interface provided at a rear side of the housing of the Function Enhancement Control Cabinet Busbar Module, FECCM, (1) connected to the power distribution busbar system (14).

7. The Function Enhancement Control Cabinet Busbar Module, FECCM, according to any of the preceding claims 1 to 6 wherein the data processing unit, DPU, (7) integrated in the housing of the Function Enhancement Control Cabinet Busbar Module, FECCM, (1) and/or the external controller connected to the control interface (4) of the Function Enhancement Control Cabinet Busbar Module, FECCM, (1) is adapted to process the measurement data, MDATA, the application device identification data and/or the device operation boundary data of the application device (15) connected to the application device interface (3) of the Function Enhancement Control Cabinet Busbar Module, FECCM, (1) in real time to optimize an electrical power supply of the connected application device (15) and/or to provide an overcurrent protection and/or to provide an overload protection to the connected application device (15) and/or to control an operation state of the connected application device (15).

8. The Function Enhancement Control Cabinet Busbar Module, FECCM, according to the preceding claims 1 to 7 wherein the application device (15) connected to the application device interface (3) provided at a front side of the housing of the Function Enhancement Control Cabinet Busbar Module, FECCM, (1) comprises an electrical load device (21A) including a resistive load, a capacitive load and/or an inductive load or comprises an adapter device for connection of a load device (21A).

9. The Function Enhancement Control Cabinet Busbar Module, FECCM, according to the preceding claims 1 to 8 wherein the data processing unit, DPU, (7) of the Function Enhancement Control Cabinet Busbar Module, FECCM, (1) is adapted to communicate with the external controller connected to the control interface (4) of the Function Enhancement Control Cabinet Busbar Module, FECCM, (1) by means of a predefined data transfer protocol including a field bus data transfer protocol or an Ethernet-based data transfer protocol.

10. The Function Enhancement Control Cabinet Busbar Module, FECCM, according to the preceding claims 1 to 9 wherein the energy interface (2) provided at a rear side of the housing of the Function Enhancement Control Cabinet Busbar Module, FECCM, (1) comprises electrical contacts protruding from the rear side of the housing of the Function Enhancement Control Cabinet Busbar Module, FECCM, (1) pluggable into corresponding slots of busbars (30) of the power distribution busbar system (14).

11. The Function Enhancement Control Cabinet Busbar Module, FECCM, according to the preceding claims 1 to 10 wherein the application device interface (3) provided at the front side of the housing of the Function Enhancement Control Cabinet Busbar Module, FECCM, (1) comprises at least one busbar portion of an internal busbar (31) included in the housing of the Function Enhancement Control Cabinet Busbar Module, FECCM, (1) and forming part of the internal bidirectional power supply path, PSP, wherein the busbar portion of the internal busbar (31) has slots (32) into which protruding electrical contacts (33) of an application device (15) are pluggable through associated contact openings (34) provided at the front side of the housing of the Function Enhancement Control Cabinet Busbar Module, FECCM, (1).

12. The Function Enhancement Control Cabinet Busbar Module, FECCM, according to the preceding claims 1 to 11 wherein the measurement unit, MU, (6) and the data processing unit, DPU, (7) integrated in an electrically isolating housing of the Function Enhancement Control Cabinet Busbar Module, FECCM, (1) are provided on a fixed or replaceable printed circuit board, PCB, surrounded by the electrically isolating housing of the Function Enhancement Control Cabinet Busbar Module, FECCM, (1).

13. The Function Enhancement Control Cabinet Busbar Module, FECCM, according to the preceding claims 1 to 12 wherein sensors of the measurement unit, MU, (6) of the Function Enhancement Control Cabinet Busbar Module, FECCM, (1) are provided at the at least one internal busbar (31) included in the housing of the Function Enhancement Control Cabinet Busbar Module, FECCM, (1) to provide measurement data, MDATA, to the data processing unit, DPU, (7) of the Function Enhancement Control Cabinet Busbar Module, FECCM, (1) indicating an amplitude or an amplitude change of an electrical current, I, flowing through the internal busbar (31) and/or an electrical voltage, V, or voltage change at the internal busbar (31) of the Function Enhancement Control Cabinet Busbar Module, FECCM, (1).

14. The Function Enhancement Control Cabinet Busbar Module, FECCM, according to the preceding claims 1 to 13 wherein the energy interface (2) provided at a rear side of the housing of the Function Enhancement Control Cabinet Busbar Module, FECCM, (1) comprises several electrical contacts for AC power supply phases,L, of a multiphase power distribution busbar system (14).

15. The Function Enhancement Control Cabinet Busbar Module, FECCM, according to the preceding claims 1 to 14 wherein the application device interface (3) provided at a front side of the housing of the Function Enhancement Control Cabinet Busbar Module, FECCM, (1) comprises several electrical contacts for AC power supply phases, L, of a multiphase application device (15) connectable to the application device interface (3) provided at the front side of the housing of the Function Enhancement Control Cabinet Busbar Module, FECCM, (1).

16. The Function Enhancement Control Cabinet Busbar Module, FECCM, according to the preceding claims 1 to 15 wherein a processor (12) of the data processing unit, DPU, (7) is adapted to calculate a phase relationship between different electrical AC power supply phases, L, supplied via different bidirectional internal power supply paths, PSPs, of the Function Enhancement Control Cabinet Busbar Module, FECCM, (1) and/or to calculate a frequency of the electrical AC power supply phases, L, based on the measurement data, MDATA, received by the data processing unit, DPU, (7) from the measurement unit, MU, (6) of the Function Enhancement Control Cabinet Busbar Module, FECCM, (1) and/or to calculate real, reactive and apparent power of each single phase, L, and summed real, reactive and apparent power values of a multiphase phase power distribution busbar system (14), and/or to accumulate energy values related to single phases or a multiphase power distribution busbar system (14).

17. The Function Enhancement Control Cabinet Busbar Module, FECCM, according to the preceding claims 1 to 16 wherein the measurement unit, MU, (6) of the Function Enhancement Control Cabinet Busbar Module, FECCM, (1) is integrated in a measurement submodule connected via an internal data and control interface to the data processing unit, DPU, (7) of the Function Enhancement Control Cabinet Busbar Module, FECCM, (1) integrated in a separate data processing submodule, wherein the measurement submodule is connectable to the data processing submodule via the internal data and control interface to provide the Function Enhancement Control Cabinet Busbar Module, FECCM, (1).

18. The Function Enhancement Control Cabinet Busbar Module, FECCM, according to the preceding claims 15 to 17 wherein the data processing unit, DPU, (7) is adapted to perform an automatic rotation field detection and/or an automatic polarity detection based on the measurement data, MDATA, received from the measurement unit, MU, (6) and/or based on the phase relationship between different electrical AC power supply phases, L, calculated by the processor of the data processing unit, DPU, (7).

19. The Function Enhancement Control Cabinet Busbar Module, FECCM, according to the preceding claims 1 to 18 wherein a microcontroller (23) or FPGA of the data processing unit, DPU, (7) is adapted to control functions of the application device (15) connected to the application device interface (3) provided at a front side of the housing of the Function Enhancement Control Cabinet Busbar Module, FECCM, (1) through an application device control interface (22) of the Function Enhancement Control Cabinet Busbar Module, FECCM, (1).

20. The Function Enhancement Control Cabinet Busbar Module, FECCM, according to the preceding claims 1 to 19 wherein an auxiliary power supply for the data processing unit, DPU, (7) of the Function Enhancement Control Cabinet Busbar Module, FECCM, (1) is provided through the control interface (4) of the Function Enhancement Control Cabinet Busbar Module, FECCM, (1).

21. The Function Enhancement Control Cabinet Busbar Module, FECCM, according to the preceding claims 1 to 20 wherein for each AC power supply phase, L, of a multiphase AC power distribution busbar system (14) a separate Function Enhancement Control Cabinet Busbar Module, FECCM, (1) is provided.

22. The Function Enhancement Control Cabinet Busbar Module, FECCM, according to the preceding claims 1 to 21 wherein a sensor provided at the internal power supply path, PSP, is adapted to generate a sensor signal supplied via gold spring elements or spring elements made of other materials to the data processing unit, DPU, (7) mounted on a printed circuit board, PCB, of the Function Enhancement Control Cabinet Busbar Module, FECCM, (1).

23. The Function Enhancement Control Cabinet Busbar Module, FECCM, according to the preceding claims 2 to 22 wherein the user visualization interface (5) comprises
a set of light emitting diodes, LED1, located at the application device interface (3) and adapted to indicate a connection state and/or an operation state of an application device (15) connected to the application device interface (3) and comprises
a set of light emitting diodes, LED2, located at the energy supply interface (2) and adapted to indicate a connection state and/or an operation state of the power distribution busbar system (14) connected to the energy supply interface (2).

24. The Function Enhancement Control Cabinet Busbar Module, FECCM, according to the preceding claims 1 to 23 wherein the measurement data, MDATA, the application device identification data and/or device operation boundary data are recorded and stored continuously or event-driven in a local non-volatile data memory (11) of the data processing unit, DPU, (7) of the Function Enhancement Control Cabinet Busbar Module, FECCM, (1).

25. The Function Enhancement Control Cabinet Busbar Module, FECCM, according to the preceding claims 1 to 24 wherein the application device (15) connected to the application device interface (3) provided at a front side of the housing of the Function Enhancement Control Cabinet Busbar Module, FECCM, (1) comprises an RFID tag storing application device identification data and/or device operation boundary data read by an RFID reading unit of the Function Enhancement Control Cabinet Busbar Module, FECCM, (1) and supplied to a processor (12)of the data processing unit, DPU, (7) of the Function Enhancement Control Cabinet Busbar Module, FECCM, (1) and/or stored in a local non-volatile data memory (11) of the data processing unit, DPU, (7).

26. A control cabinet (13) including
one or more Function Enhancement Control Cabinet Busbar Modules, FECCMs, (1) according to any of the preceding claims 1 to 25 wherein each Function Enhancement Control Cabinet Busbar Module, FECCM, (1) mounted in the control cabinet (13) comprises an energy interface (2) connected to at least one busbar (30) of a power distribution busbar system (14) of the control cabinet (13) and comprises an application device interface (3) for connection of at least one application device (15) via a bidirectional internal power supply path, PSP, of the Function Enhancement Control Cabinet Busbar Module, FECCM, (1) to the at least one busbar (30) of the power distribution busbar system (14) of the control cabinet (13) and further comprises a control interface (4) provided for connection of the respective Function Enhancement Control Cabinet Busbar Module, FECCM, (1) to a controller (17) of the control cabinet (13).

27. The control cabinet according to claim 26 wherein a rear side of the housing of the Function Enhancement Control Cabinet Busbar Module, FECCM, (1) is mountable to a rail of the control cabinet (13).

28. The control cabinet according to claim 26 or claim 27 wherein the control cabinet (13) comprises a cabinet interface (18) for providing a data connection to a central control unit (20) of an automation system.
